# EUROPEAN PATENT APPLICATION

(11) **EP 3 766 887 A1**
(43) Date of publication of application: **20.01.2021**
(21) Application number: 19766727.2
(22) Date of filing: 13.03.2019
(51) Int. Cl.: C07F 7/10, H01B 1/12, H01L 51/50, C07B 61/00

(54) **ANILINE DERIVATIVE AND USE THEREOF**

(30) Priority: 16.03.2018 JP 2018049589
(71) Applicant: Nissan Chemical Corporation, Tokyo 103-6119 (JP)
(72) Inventor: TERAI Seiya, Funabashi-shi, Chiba 274-0052 (JP); ENDO Toshiyuki, Funabashi-shi, Chiba 274-0052 (JP)
(74) Representative: Mewburn Ellis LLP
(86) International application number: PCT/JP2019/010345
(87) International publication number: WO 2019/177043

(57) **Abstract**

An aniline derivative represented by formula (1) is provided. 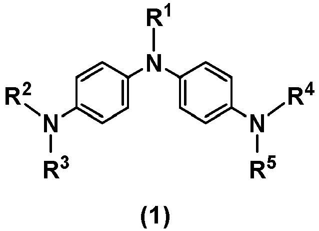 [In formula (1), R¹ to R⁵ are each independently a hydrogen atom or a group represented by formula (2) or (3) 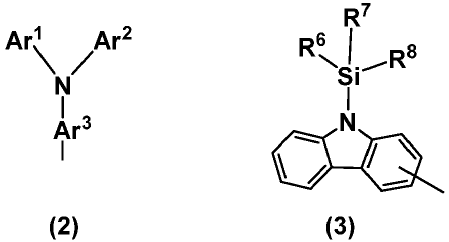 (wherein Ar¹ and Ar² each independently represent a C₆₋₂₀ aryl group and Ar³ represents a C₆₋₂₀ arylene group, any two of Ar¹ to Ar³ may be bonded to each other to form a ring in cooperation with the nitrogen atom, R⁶ to R⁸ each independently represent a C₁₋₂₀ alkyl or C₆₋₂₀ aryl group optionally substituted by W¹, and W¹ represents a halogen atom, a nitro group, a C₁₋₂₀ alkoxy group, or a cyano group), at least one of R¹ to R⁵ being a group represented by formula (3).]

## Description

### TECHNICAL FIELD

The present invention relates to aniline derivatives and their use.

### BACKGROUND ART

Charge-transporting thin films consisting of organic compounds are used as light-emitting layers and charge-injecting layers in electronic devices, particularly in organic electroluminescent (hereinafter referred to as organic EL) devices. In particular, a hole-injecting layer is responsible for transferring charge between an anode and a hole-transporting layer or a light-emitting layer, and thus serves an important function in achieving low-voltage driving and high brightness in organic EL devices.

Methods for forming the hole-injecting layer are broadly divided into dry processes typified by vapor deposition and wet processes typified by spin coating, and comparing these different processes, wet processes are better able to efficiently produce thin films having a high flatness over a large area. Hence, with the progress currently underway toward larger-area organic EL displays, there exists a desire for a hole-injecting layer that can be formed by a wet process.

In view of these circumstances, the inventors have developed charge-transporting materials which can be employed in various wet processes and which moreover give thin films that, when used as hole-injecting layers for organic EL devices, are capable of achieving excellent EL device characteristics, and compounds which have a good solubility in organic solvents used in such charge-transporting materials (see, for example, Patent Documents 1 to 4).

### PRIOR ART DOCUMENTS

### PATENT DOCUMENTS

Patent Document 1: WO 2008/067276
Patent Document 2: WO 2008/129947
Patent Document 3: WO 2006/025342
Patent Document 4: WO 2010/058777

### SUMMARY OF INVENTION

### TECHNICAL PROBLEM

An object of this invention is to provide novel aniline derivatives which, as with the hitherto developed art disclosed in the above patent publications, exhibit good solubility in organic solvents and, when formed into a thin film and used as a hole-injecting layer, enable organic EL devices endowed with excellent brightness characteristics to be achieved.

### SOLUTION TO PROBLEM

The inventors have conducted extensive investigations in order to achieve the above object, as a result of which they have found that aniline derivatives having a predetermined silyl group on a nitrogen atom of a carbazole group have an excellent solubility in organic solvents, and a thin film exhibiting high charge transportability is obtained from varnishes prepared by dissolving such aniline derivatives in organic solvents, and also that when the thin film is used as a hole-injecting layer in an organic EL device, a device having a high brightness is obtained, thereby completing the invention.

That is, the invention provides:
1. an aniline derivative of formula (1): 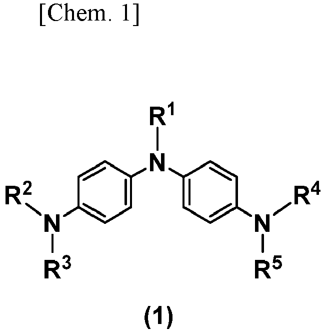 wherein R¹ to R⁵ are each independently a hydrogen atom, or a group of formula (2) or formula (3): 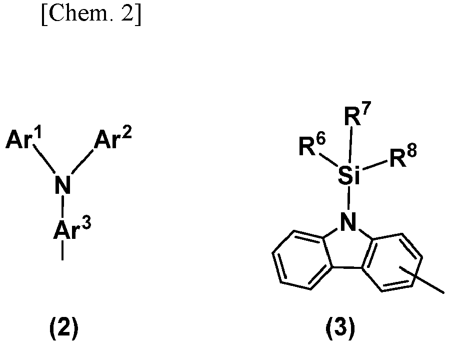 (wherein Ar¹ and Ar² are each independently an aryl group of 6 to 20 carbon atoms, Ar³ is an arylene group of 6 to 20 carbon atoms, and any two of Ar¹ to Ar³ may be bonded to each other to form a ring with a nitrogen atom, R⁶ to R⁸ are each independently an alkyl group of 1 to 20 carbon atoms or aryl group of 6 to 20 carbon atoms which may be substituted with W¹, and W¹ is a halogen atom, a nitro group, an alkoxy group of 1 to 20 carbon atoms or a cyano group)
   and at least one of R¹ to R⁵ is a group of formula (3);
2. the aniline derivative of 1, wherein R¹ to R⁵ are all groups of formula (3);
3. the aniline derivative of 1 or 2, wherein R⁶ to R⁸ are alkyl groups of 1 to 10 carbon atoms or aryl groups of 6 to 10 carbon atoms;
4. the aniline derivative of 3, wherein two of R⁶ to R⁸ are methyl groups and the remaining one is a t-butyl group;
5. a charge-transporting substance containing the aniline derivative of any one of 1 to 4;
6. a charge-transporting material containing the charge-transporting substance of 5;
7. a charge-transporting varnish containing the charge-transporting substance of 5 and an organic solvent;
8. the charge-transporting varnish according to 7, further containing a dopant;
9. the charge-transporting varnish of 8, wherein the dopant is at least one selected from aryl sulfonic acids and aryl sulfonates;
10. a charge-transporting thin film produced using the charge-transporting varnish of any one of 7 to 9;
11. an electronic device having the charge-transporting thin film of 10;
12. an organic electroluminescent device having the charge-transporting thin film of 10;
13. the organic electroluminescent device of 12, wherein the charge-transporting thin film is a hole-injecting layer or a hole-transporting layer; and
14. a method for producing an aniline derivative of formula (1): 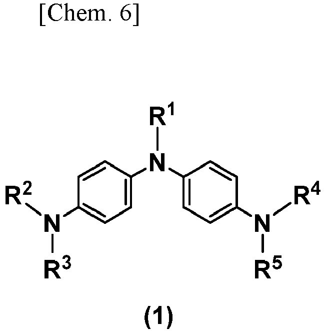 wherein R¹ to R⁵ are each independently a hydrogen atom, or a group of formula (2) or formula (3): 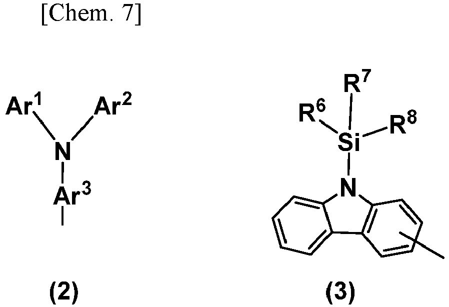
   (wherein Ar¹ to Ar³ and R⁶ to R⁸ have the same meaning as below)
   and at least one of R¹ to R⁵ is a group of formula (3),
   the method including causing a coupling reaction of an amine compound of formula (1'): 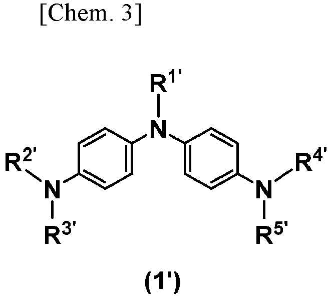 wherein R^{1'} to R^{5'} are each independently a hydrogen atom or a group of formula (2): 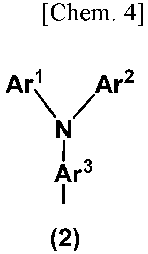
      (wherein Ar¹ and Ar² are each independently an aryl group of 6 to 20 carbon atoms, Ar³ is an arylene group of 6 to 20 carbon atoms, and any two of Ar¹ to Ar³ may be bonded to each other to form a ring with a nitrogen atom)
      and at least one of R^{1'} to R^{5'} is a hydrogen atom;
      with a carbazole compound of formula (3'): 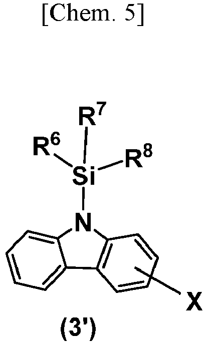
   wherein X is a halogen atom or a pseudohalogen atom, R⁶ to R⁸ are each independently an alkyl group of 1 to 20 carbon atoms or aryl group of 6 to 20 carbon atoms which may be substituted with W¹, and W¹ is an alkoxy group of 1 to 20 carbon atoms, a halogen atom, a nitro group, or a cyano group,
   in the presence of a catalyst and a base.

### ADVANTAGEOUS EFFECTS OF INVENTION

The aniline derivative of the invention dissolves readily in organic solvents, and by dissolving this together with a dopant in an organic solvent, a charge-transporting varnish can be easily prepared.

Thin films produced from the charge-transporting varnish of the invention exhibit high charge transportability and therefore can be suitably used as thin films for electronic devices such as organic EL devices. In particular, by using such a thin film as a hole-injecting layer in an organic EL device, organic EL devices of excellent brightness characteristics can be obtained.

Further, the charge-transporting varnish of the invention can reproducibly form thin films having excellent charge transportability, even using various wet processes capable of film formation over a large area, such as spin coating and slit coating, and therefore is also capable of fully accommodating recent advances in the field of organic EL devices.

### DESCRIPTION OF EMBODIMENTS

The invention is described more fully below.

The aniline derivative according to this invention has formula (1).

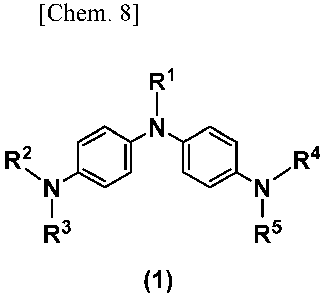

In formula (1), R¹ to R⁵ are each independently a hydrogen atom, or a group of formula (2) or formula (3), and at least one of R¹ to R⁵ is a group of formula (3).

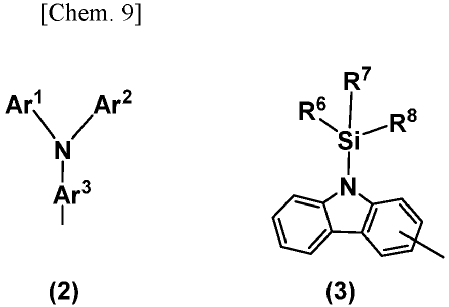

In formula (2), Ar¹ and Ar² are each independently an aryl group of 6 to 20 carbon atoms, Ar³ is an arylene group of 6 to 20 carbon atoms, and any two of Ar¹ to Ar³ may be bonded to each other to form a ring with a nitrogen atom.

Specific examples of the aryl group of 6 to 20 carbon atoms include phenyl, 1-naphthyl, 2-naphthyl, 1-anthryl, 2-anthryl, 9-anthryl, 1-phenanthryl, 2-phenanthryl, 3-phenanthryl, 4 phenanthryl, and 9-phenanthryl groups.

Specific examples of the arylene group of 6 to 20 carbon atoms include benzene-1,2-diyl(o-phenylene), benzene-1,3-diyl(m-phenylene), benzene-1,4-diyl(p-phenylene), naphthalene-1,2-diyl, naphthalene-1,3-diyl, naphthalene-1,4-diyl, naphthalene-1,5-diyl, naphthalene-1,6-diyl, naphthalene-1,7-diyl, and naphthalene-1,8-diyl groups.

In addition, the ring formed by combining any two of Ar¹ to Ar³ with a nitrogen atom include a carbazole ring and the like.

Of these, Ar¹ and Ar² are preferably a phenyl group, a 1-naphthyl group, and a 2-naphthyl group, and more preferably a phenyl group.

Further, Ar³ is preferably a benzene-1,2-diyl group, a benzene-1,3-diyl group, or a benzene-1,4-diyl group, and more preferably a benzene-1,4-diyl group.

Therefore, the group of formula (2) is preferably a group of formula (2A), and more preferably a group of formula (2A-1).

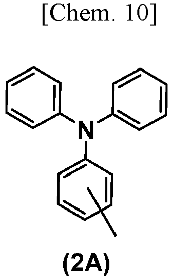

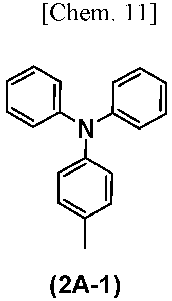

In formula (3), R⁶ to R⁸ are each independently an alkyl group of 1 to 20 carbon atoms or aryl group of 6 to 20 carbon atoms which may be substituted with W¹, and W¹ is an alkoxy group of 1 to 20 carbon atoms, a halogen atom, a nitro group, or a cyano group.

The alkyl group of 1 to 20 carbon atoms may be linear, branched, or cyclic, and examples include linear or branched alkyl groups of 1 to 20 carbon atoms, such as methyl, ethyl, n-propyl, isopropyl, n-butyl, isobutyl, s-butyl, t-butyl, n-pentyl, n-hexyl, n-heptyl, n-octyl, n-nonyl, and n-decyl groups; and cyclic alkyl groups of 3 to 20 carbon atoms, such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl, and bicyclodecyl groups.

The aryl groups of 6 to 20 carbon atoms are the same as above.

For the alkoxy group of 1 to 20 carbon atoms, the alkyl group therein may be linear, branched, or cyclic, and examples include linear or branched alkoxy groups of 1 to 20 carbon atoms, such as methoxy, ethoxy, n-propoxy, isopropoxy, n-butoxy, t-butoxy, n-pentyloxy, n-hexyloxy, n-heptyloxy, n-octyloxy, n-nonyloxy, and n-decyloxy groups; and cyclic alkyloxy group of 3 to 20 carbon atoms, such as cyclopentyloxy and cyclohexyloxy groups.

Examples of the halogen atom include fluorine, chlorine, bromine, and iodine atoms.

Of these, R⁶ to R⁸ are preferably alkyl groups of 1 to 10 carbon atoms or aryl groups of 6 to 10 carbon atoms, and more preferably alkyl groups of 1 to 5 carbon atoms.

More specifically, a combination of two of R⁶ to R⁸ being methyl groups and the remaining one being a t-butyl group, a combination of two of R⁶ to R⁸ being phenyl groups and the remaining one being a t-butyl group, and all of R⁶ to R⁸ being isopropyl groups are preferred, and a combination of two of R⁶ to R⁸ being methyl groups and the remaining one being a t-butyl group is more preferred.

Therefore, the group of the above formula (3) is preferably a group of the following formula (3A), and even more preferably a group of the following formula (3A-1).

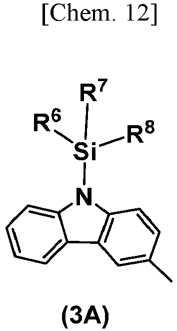

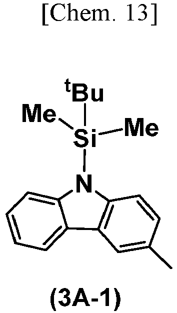

The aniline derivative of the above formula (1) preferably has symmetry from the standpoint of ease of synthesis. Specific examples thereof include a compound of the following formula (1A) in which all of R¹ to R⁵ are groups of the above formula (3A-1), a compound of the following formula (1B) in which R¹, R³, and R⁵ are hydrogen atoms, and R² and R⁴ are groups of the above formula (3A-1), a compound of the following formula (1C) in which R¹, R³, and R⁵ are groups of the above formula (2A-1), and R² and R⁴ are groups of the above formula (3A-1), and a compound of the following formula (1D) in which R¹, R³, and R⁵ are groups of the above formula (3A-1), and R² and R⁴ are groups of the above formula (2A-1), but are not limited thereto.

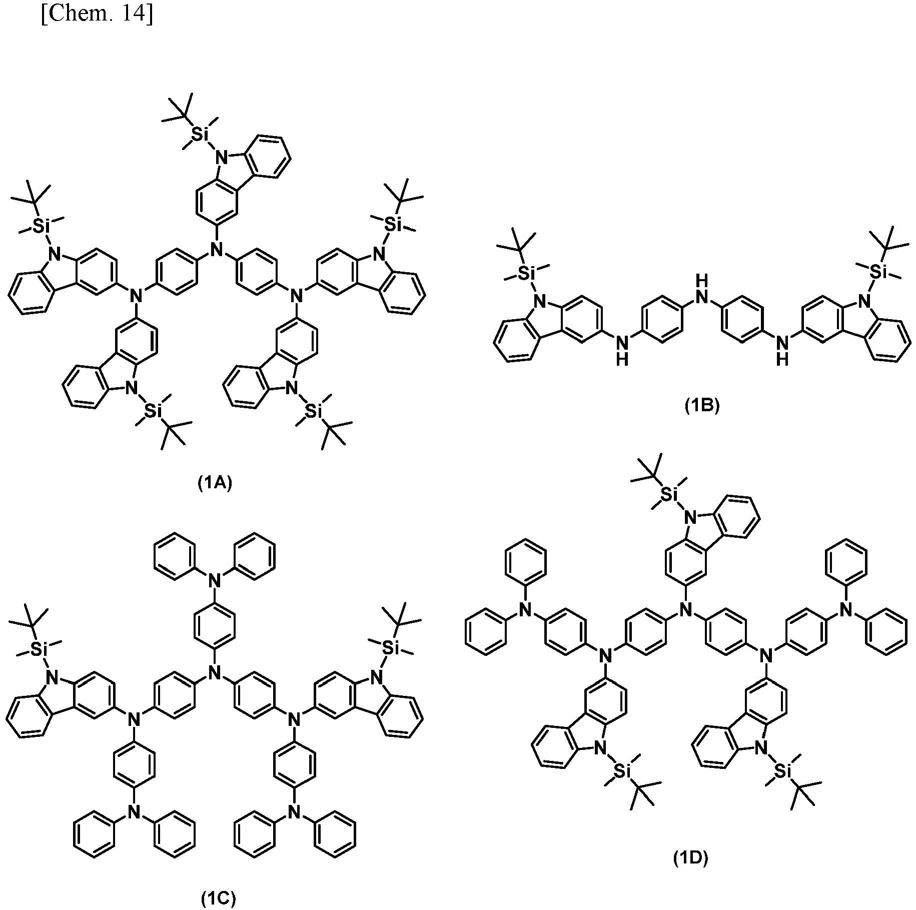

The aniline derivative of formula (1) of the invention can be produced by causing a coupling reaction of an amine compound of the following formula (1') with a carbazole compound of the following formula (3') in the presence of a catalyst and a base.

The compound of formula (3') can be obtained by a known method of reacting the corresponding carbazole with a triorganohalide such as trialkylsilyl chloride in the presence of a base such as NaH.

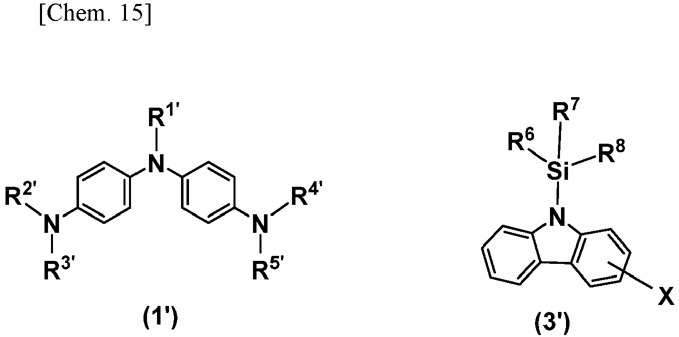

In formula (1), R^{1'} to R^{5'} are each independently a hydrogen atom or a group of formula (2), and at least one of R^{1'} to R^{5'} is a hydrogen atom.

In formula (3'), R⁶ to R⁸ are the same as those described in the above formula (3), and X is a halogen atom or a pseudohalogen atom.

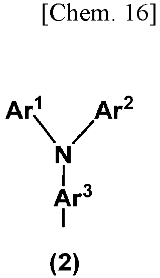

In formula (2), Ar¹ to Ar³ are the same as above.

The halogen atom is exemplified in the same way as above.

Examples of the pseudohalogen group include (fluoro)alkylsulfonyloxy groups such as methanesulfonyloxy, trifluoromethanesulfonyloxy, and nonafluorobutanesulfonyloxy groups; and aromatic sulfonyloxy groups such as benzenesulfonyloxy and toluenesulfonyloxy groups.

Of these, X is preferably a halogen atom, and more preferably a bromine atom or an iodine atom, in consideration of availability and reactivity of raw materials and the like.

Also, the substitution position of X is not particularly limited, but is preferably para to the nitrogen atom of carbazole.

In the coupling reaction between the amine compound of the above formula (1') and the carbazole compound of formula (3'), the charging ratio of the amine compound of formula (1') and the carbazole compound of formula (3') is, in the amount of substance (mol) ratio, preferably about 1 to 5 carbazole compounds, and more preferably about 1.1 to 2, with respect to 1 NH group of the amine compound.

Examples of the catalyst used in the reaction include copper catalysts such as copper chloride, copper bromide, and copper iodide; and palladium catalysts such as Pd(PPh₃)₄ (tetrakis(triphenylphosphine)palladium), Pd(PPh₃)₂Cl₂ (bis(triphenylphosphine)dichloropalladium), Pd(dba)₂ (bis(benzylideneacetone)palladium), Pd₂(dba)₃ (tris(benzylideneacetone)dipalladium), Pd(P-t-Bu₃)₂ (bis(tri(t-butylphosphine))palladium), and Pd(OAc)₂ (palladium acetate). These catalysts may be used singly, or two or more may be used in combination.

Also, these catalysts may be used together with suitable known ligands.

Examples of such ligands include tertiary phosphines such as triphenylphosphine, tri-o-tolylphosphine, diphenylmethylphosphine, phenyldimethylphosphine, trimethylphosphine, triethylphosphine, tributylphosphine, tri-t-butylphosphine, di-t-butyl(phenyl)phosphine, di-t-butyl(4-dimethylaminophenyl)phosphine, 1,2-bis(diphenylphosphino)ethane, 1,3 -bis(diphenylphosphino)propane, 1,4-bis(diphenylphosphino)butane, and 1,1'-bis(diphenylphosphino)ferrocene; and tertiary phosphites such as trimethylphosphite, triethylphosphite, and triphenylphosphite, and di-t-butyl(phenyl)phosphine is preferably used in the invention.

The amount of catalyst used can be each set to about 0.001 to 1 mol per mole of the target NH group to be reacted with the amine compound of formula (1'), and is preferably about 0.01 to 0.1 mol, more preferably about 0.02 to 0.05 mol, and even more preferably about 0.02 mol.

In addition, when ligands are used, the amount thereof can be set to 0.1 to 5 equivalents, and is preferably 1 to 2 equivalents, per the metal complex used.

Further, examples of the base include alkali metal simple substances such as lithium, sodium, potassium, lithium hydride, sodium hydride, potassium hydroxide, t-butoxy lithium, t-butoxy sodium, t-butoxy potassium, lithium hydroxide, sodium hydroxide, potassium hydroxide, sodium carbonate, potassium carbonate, sodium hydrogen carbonate, and potassium hydrogen carbonate, alkali metal hydroxides, alkoxy alkali metals, alkali metal carbonates, and alkali metal hydrogen carbonates; and alkaline earth metal carbonates such as calcium carbonate, and in consideration of efficient progress of the coupling reaction, t-butoxy sodium is preferred.

The amount of base used is preferably about 1 to 2 equivalents, and more preferably about 1.2 to 1.5 equivalents, per the target NH group to be reacted with the amine compound of formula (1').

In cases where starting compounds are all solids or from the standpoint of efficiently obtaining the target coupling product, each of the above reactions is carried out in a solvent. When a solvent is used, the type thereof is not particularly limited, provided that it does not have an adverse influence on the reaction. Specific examples include aliphatic hydrocarbons (pentane, n-hexane, n-octane, n-decane, decalin, etc.), halogenated aliphatic hydrocarbons (chloroform, dichloromethane, dichloroethane, carbon tetrachloride, etc.), aromatic hydrocarbons (benzene, nitrobenzene, toluene, o-xylene, m-xylene, p-xylene, mesitylene, etc.), halogenated aromatic hydrocarbons (chlorobenzene, bromobenzene, o-dichlorobenzene, m-dichlorobenzene, p-dichlorobenzene, etc.), ethers (diethyl ether, diisopropyl ether, t-butyl methyl ether, tetrahydrofuran, dioxane, 1,2-dimethoxyethane, 1,2-diethoxyethane, etc.), ketones (acetone, methyl ethyl ketone, methyl isobutyl ketone, di-n-butyl ketone, cyclohexanone, etc.), amides (N,N-dimethylformamide, N,N-dimethylacetamide, etc.), lactams and lactones (N-methylpyrrolidone, γ-butyrolactone, etc.), urea (N,N-dimethylimidazolidinone, tetramethylurea, etc.), sulfoxides (dimethylsulfoxide, sulfolane, etc.), and nitriles (acetonitrile, propionitrile, butyronitrile, etc.). These solvents may be used singly, or two or more may be used in admixture.

Of these, aromatic hydrocarbons are particularly preferred, and toluene is more preferred.

The reaction temperature may be suitably set in the range of the melting point to the boiling point of the solvent to be used, and is preferably about 0 to 200°C, and more preferably about 20 to 150°C, and in consideration of enhancing the yield of the coupling product, even more preferably about 40 to 100°C.

After completion of the reaction, the target aniline derivative (coupling product) can be obtained by post-treatment in the usual manner.

The charge-transporting varnish of the invention includes a charge-transporting substance consisting of the aniline derivative of formula (1), and an organic solvent. Depending on the intended use of the resulting thin film, the charge-transporting varnish may contain a dopant substance for the purpose of enhancing the charge transportability and the like.

The dopant substance is not particularly limited, provided that it dissolves in at least one of the solvents used in the varnish, and either an inorganic dopant substance or an organic dopant substance can be used.

As the inorganic dopant substance, a heteropolyacid is preferred, and specific examples thereof include phosphomolybdic acid, silicomolybdic acid, phosphotungstic acid, phosphorus tungstomolybdic acid, and silicotungstic acid.

The heteropolyacid has a structure in which a hetero atom is located at the center of the molecule, which is typically represented by a Keggin type chemical structure of formula (D1) or a Dawson type chemical structure of formula (D2), and is a polyacid formed through condensation of an isopolyacid which is an oxyacid of vanadium (V), molybdenum (Mo), tungsten (W), or the like with an oxyacid of a different element. Examples of such an oxyacid of a different element include oxyacids of silicon (Si), phosphorus (P), and arsenic (As).

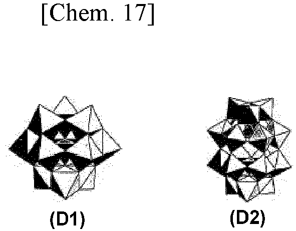

Specific examples of the heteropolyacid include phosphomolybdic acid, silicomolybdic acid, phosphotungstic acid, silicotungstic acid, and phosphorus tungstomolybdic acid, and these may be used singly, or two or more may be used in combination. The heteropolyacid used in the invention is commercially available or can be synthesized by a known method.

Particularly, when using one heteropolyacid, the one heteropolyacid is preferably phosphotungstic acid or phosphomolybdic acid, and most suitably phosphotungstic acid. Also, when two or more heteropolyacids are used, one of the two or more heteropolyacids is preferably phosphotungstic acid or phosphomolybdic acid, and more preferably phosphotungstic acid.

Even if a heteropolyacid having, in quantitative analysis such as elemental analysis, the number of elements which is higher or lower than that in the structure quantitative by the general formula can be used in this invention, so long as it was acquired as a commercial product or appropriately synthesized according to a known method of synthesis.

That is, for example, phosphotungstic acid is generally represented by chemical formula H₃(PW₁₂O₄₀)·nH₂O and phosphomolybdic acid is generally represented by chemical formula H₃(PMo₁₂O₄₀)·nH₂O, and in quantitative analysis, regardless of whether the number of elements P (phosphorus), O (oxygen), or W (tungsten) or Mo (molybdenum) in these formulas is high or low, so long as the heteropolyacid was acquired as a commercial product or appropriately synthesized according to a known method of synthesis, it can be used in this invention. In such cases, the weight of the heteropolyacid specified in the invention does not mean the weight of pure phosphotungstic acid in the synthetic product or the commercial product (phosphotungstic acid content), but rather means, in the form that is available as a commercial product or the form that can be isolated by a known synthesis method, the total weight in the state of containing hydrated water, other impurities, and the like.

The heteropolyacid contained in the charge-transporting varnish of the invention can be set to, in a weight ratio, about 0.01 to 50, with respect to the charge-transporting substance 1, and is preferably about 0.1 to 10, and more preferably 1.0 to 5.0.

Moreover, examples of the organic dopant substances include aryl sulfonic acids, aryl sulfonates, ionic compounds composed of a predetermined anion and its counter cation, tetracyanoquinodimethane derivatives and benzoquinone derivatives.

As the aryl sulfonic acid, a compound of the following formula (4) or (5) can be preferably used.

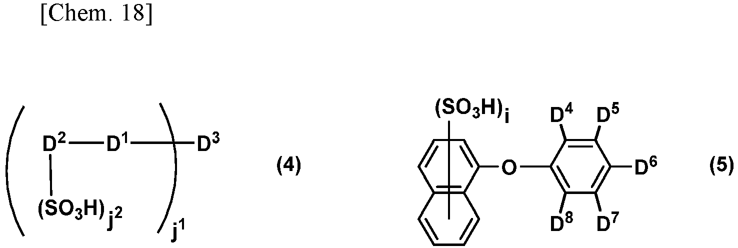

In formula (4), D¹ is -O- or S-, and -O- is preferred. D² is a naphthalene ring or an anthracene ring, and a naphthalene ring is preferred. D³ is a divalent to tetravalent perfluorobiphenyl group, j¹ is the number of bonds between D¹ and D³, and is an integer that satisfies 2 ≤ j¹ ≤ 4, but D³ is a divalent perfluorobiphenyl group, and j¹ is preferably 2. j² is the number of sulfonic acid groups bonded to D², and is an integer that satisfies 1 ≤ j² ≤ 4, and is preferably 2.

In formula (5), D⁴ to D⁸ are each independently a hydrogen atom, a halogen atom, a cyano group, an alkyl group of 1 to 20 carbon atoms, a halogenated alkyl group of 1 to 20 carbon atoms, or a halogenated alkenyl group of 2 to 20 carbon atoms, and at least three of D⁴ to D⁸ are halogen atoms. i is the number of sulfonic acid groups bonded to the naphthalene ring, and is an integer that satisfies 1 ≤ i ≤ 4, and is preferably 2 to 4, and more preferably 2.

Examples of the halogenated alkyl groups of 1 to 20 carbon atoms include trifluoromethyl, 2,2,2-trifluoroethyl, perfluoroethyl, 3,3,3-trifluoropropyl, 2,2,3,3,3-pentafluoropropyl, perfluoropropyl, 4,4,4-trifluorobutyl, 3,3,4,4,4-pentafluorobutyl, 2,2,3,3,4,4,4-heptafluorobutyl, and perfluorobutyl groups. Examples of the halogenated alkenyl group of 2 to 20 carbon atoms include perfluorovinyl, 1-perfluoropropenyl, perfluoroallyl, and perfluorobutenyl groups.

The halogen atoms and alkyl groups of 1 to 20 carbon atoms are exemplified in the same way as above, but the halogen atom is preferably a fluorine atom.

Of these, it is preferable that D⁴ to D⁸ are each a hydrogen atom, a halogen atom, a cyano group, an alkyl group of 1 to 10 carbon atoms, a halogenated alkyl group of 1 to 10 carbon atoms, or a halogenated alkenyl group of 2 to 10 carbon atoms, and at least three of D⁴ to D⁸ are fluorine atoms; more preferable that D⁴ to D⁸ are each a hydrogen atom, a fluorine atom, a cyano group, an alkyl group of 1 to 5 carbon atoms, a fluorinated alkyl group of 1 to 5 carbon atoms, or a fluorinated alkenyl group of 2 to 5 carbon atoms, and at least three of D⁴ to D⁸ are fluorine atoms; and even more preferable that D⁴ to D⁸ are each a hydrogen atom, a fluorine atom, a cyano group, a perfluoroalkyl group of 1 to 5 carbon atoms, or a perfluoroalkenyl group of 1 to 5 carbon atoms, and D⁴, D⁵, and D⁸ are fluorine atoms.

In addition, the perfluoroalkyl group refers to an alkyl group in which all the hydrogen atoms are substituted with fluorine atoms, and the perfluoroalkenyl group refers to an alkenyl group in which all the hydrogen atoms are substituted with fluorine atoms.

Specific examples of suitable aryl sulfonic acids include, but are not limited to, those shown below.

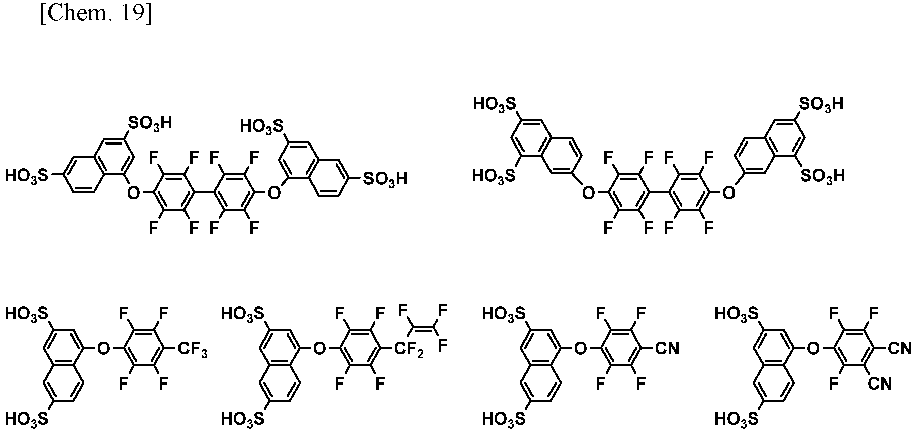

When the charge-transporting varnish of the invention contains an aryl sulfonic acid, the content thereof is, in a molar ratio, preferably about 0.01 to 20.0, and more preferably about 0.4 to 5.0, with respect to the charge-transporting substance 1.

As the aryl sulfonate compound, a compound of the following formula (6) or (6') can be preferably used.

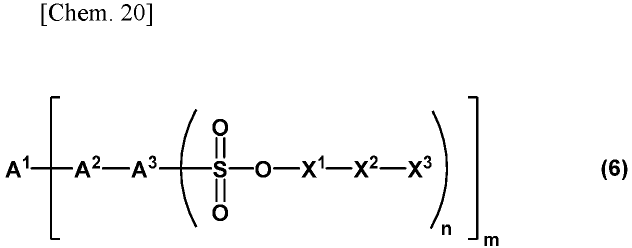

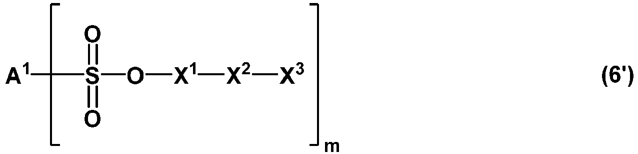

In formulas (6) and (6'), A¹ is an optionally substituted m-valent hydrocarbon group of 6 to 20 carbon atoms containing one or more aromatic rings, or an m-valent group derived from a compound of the following formula (7) or (8). 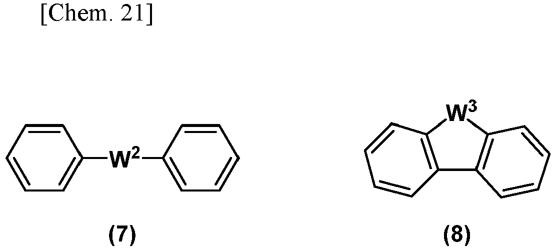 wherein W² and W³ are each independently -O-, -S-, -S(O)-, or -S(O₂)-, or -N-, -Si-, -P-, or -P(O)- optionally having a substituent.

The m-valent hydrocarbon group of 6 to 20 carbon atoms containing one or more aromatic rings is a group obtained by removing m hydrogen atoms from a hydrocarbon of 6 to 20 carbon atoms containing one or more aromatic rings. Examples of the hydrocarbon containing one or more aromatic rings include benzene, toluene, xylene, biphenyl, naphthalene, anthracene, and pyrene. Of these, the hydrocarbon group is preferably a group derived from benzene, biphenyl, or the like.

In the hydrocarbon group, some or all of the hydrogen atoms may be further substituted with substituents. As the substituents, some or all of the hydrogen atoms may be substituted with a fluorine atom, a chlorine atom, a bromine atom, an iodine atom, a nitro group, a cyano group, a hydroxy group, an amino group, a silanol group, a thiol group, a carboxy group, a sulfonate group, a phosphoric acid group, a phosphate group, an ester group, a thioester group, an amide group, a monovalent hydrocarbon group, an organooxy group, an organoamino group, an organosilyl group, an organothio group, an acyl group, a sulfo group, or the like.

Here, examples of the monovalent hydrocarbon group include alkyl groups of 1 to 10 carbon atoms such as methyl, ethyl, n-propyl, isopropyl, n-butyl, isobutyl, sec-butyl, tert-butyl, n-pentyl, cyclopentyl, n-hexyl, cyclohexyl, n-heptyl, n-octyl, n-nonyl, and n-decyl groups; alkenyl group of 2 to 10 carbon atoms such as vinyl, 1-propenyl, 2-propenyl, isopropenyl, 1-methyl-2-propenyl, 1-butenyl, 2-butenyl, 3-butenyl, and hexenyl groups; aryl groups of 6 to 20 carbon atoms such as phenyl, xylyl, tolyl, 1-naphthyl, and 2-naphthyl groups; and aralkyl groups of 7 to 20 carbon atoms such as benzyl and phenyl ethyl groups.

Examples of the organooxy group include alkoxy, alkenyloxy, and aryloxy groups. Examples of the alkyl, alkenyl, and aryl groups contained in the group include the same ones as those mentioned above.

Examples of the organoamino group include alkylamino groups of 1 to 12 carbon atoms such as methylamino, ethylamino, propylamino, butylamino, pentylamino, hexylamino, cyclohexylamino, heptylamino, octylamino, nonylamino, decylamino, and dodecyl amino groups; dialkylamino groups in which each alkyl group such as a dimethylamino group, a diethylamino group, a dipropylamino group, a dibutylamino group, a dipentylamino group, a dihexylamino group, a dicyclohexylamino group, a diheptylamino group, a dioctylamino group, a dinonylamino group, and a didecylamino group is an alkyl group of 1 to 12 carbon atoms; and a morpholino group.

Examples of the organosilyl group include trialkylsilyl groups in which each alkyl group such as a trimethylsilyl group, a triethylsilyl group, a tripropylsily group, a tributylsilyl group, a tripentylsilyl group, a trihexylsilyl group, a pentyldimethylsilyl group, a hexyldimethylsilyl group, an octyldimethylsilyl group, and a decyldimethylsilyl group is an alkyl group of 1 to 10 carbon atoms.

Examples of the organothio group include alkylthio groups of 1 to 12 carbon atoms such as methylthio, ethylthio, propylthio, butylthio, pentylthio, hexylthio, heptylthio, octylthio, nonylthio, decylthio, and dodecylthio groups.

Examples of the acyl group include acyl groups of 1 to 10 carbon atoms such as formyl, acetyl, propionyl, butyryl, isobutyryl, valeryl, isovaleryl, and benzoyl groups.

Here, the carbon number of the monovalent hydrocarbon group, the organooxy group, the organoamino group, the organoamino group, the organosilyl group, the organothio group, and the acyl group is preferably 1 to 8.

Of these substituents, a fluorine atom, a sulfonic acid group, an alkyl group, an organooxy group, and an organosilyl group are more preferred.

In formula (6), A² is -O-, -S-, or NH-. Of these, -O- is preferred because of easy synthesis.

In formula (6), A³ is a (n+1)-valent aromatic group of 6 to 20 carbon atoms. The aromatic group is a group obtained by removing (n+1) hydrogen atoms on an aromatic ring from an aromatic compound of 6 to 20 carbon atoms. In addition, in this invention, an aromatic compound means an aromatic hydrocarbon and an aromatic heterocyclic compound. Examples of the aromatic compound include benzene, toluene, xylene, biphenyl, naphthalene, anthracene, and pyrene. Of these, the aromatic group of A³ is preferably a group derived from naphthalene or anthracene.

In formulas (6) and (6'), X¹ is an alkylene group of 2 to 5 carbon atoms, and the alkylene group has -O-, -S-, or a carbonyl group interposed between the carbon atoms or some or all of the hydrogen atoms may be further substituted with alkyl groups of 1 to 20 carbon atoms. X¹ is preferably an ethylene group, a trimethylene group, a methyleneoxymethylene group, a methylenethiomethylene group, or the like, and some or all of the hydrogen atoms of these groups may be further substituted with alkyl groups of 1 to 20 carbon atoms. Examples of the alkyl group include methyl, ethyl, n-propyl, isopropyl, n-butyl, isobutyl, sec-butyl, tert-butyl, n-pentyl, cyclopentyl, n-hexyl, cyclohexyl, n-heptyl, n-octyl, n-nonyl, n-decyl, n-undecyl, n-dodecyl, and bicyclohexyl groups.

In formulas (6) and (6'), X² is a single bond, -O-, -S-, or NR^{a}-. R^{a} is a hydrogen atom or a monovalent hydrocarbon group of 1 to 10 carbon atoms. The monovalent hydrocarbon group is preferably an alkyl group such as a methyl group, an ethyl group, or an n-propyl group. X² is preferably a single bond, -O-, or S-, and more preferably a single bond or O-.

In formulas (6) and (6'), X³ is an optionally substituted monovalent hydrocarbon group of 1 to 20 carbon atoms. Examples of the monovalent hydrocarbon group include alkyl groups of 1 to 20 carbon atoms such as methyl, ethyl, n-propyl, isopropyl, n-butyl, isobutyl, sec-butyl, tert-butyl, n-pentyl, cyclopentyl, n-hexyl, cyclohexyl, n-heptyl, n-octyl, n-nonyl, n-decyl, n-undecyl, n-dodecyl, and bicyclohexyl groups; alkenyl group of 2 to 20 carbon atoms such as vinyl, 1-propenyl, 2-propenyl, isopropenyl, 1-methyl-2-propenyl, 1-butenyl, 2-butenyl, 3-butenyl, and hexenyl groups; aryl groups of 6 to 20 carbon atoms such as phenyl, xylyl, tolyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 2-biphenylyl, 3-biphenylyl, and 4-biphenylyl groups; and aralkyl groups of 7 to 20 carbon atoms such as benzyl, phenylethyl, and phenylcyclohexyl groups. Further, some or all of the hydrogen atoms of the monovalent hydrocarbon group may be further substituted with substituents. Examples of the substituent include the same ones as those described in the description of A¹. X³ is preferably an alkyl group of 1 to 20 carbon atoms or an aryl group of 6 to 20 carbon atoms.

In formulas (6) and (6'), m is an integer that satisfies 1 ≤ m ≤ 4, and is preferably 2. n is an integer that satisfies 1 ≤ n ≤ 4, and is preferably 2.

The aryl sulfonate compound of formula (6) or (6') has high solubility in a wide range of solvents including low polar solvents, so that it is possible to adjust physical properties of solutions using a wide variety of solvents, and coating properties are high. Therefore, it is preferable to apply the aryl sulfonate compound in the state of sulfonate to generate a sulfonic acid when a coating film is dried or baked. The temperature at which the sulfonic acid is generated from the sulfonate is preferably 40 to 260°C, since it is preferably stable at room temperature and at a baking temperature or lower. Further, in consideration of high stability in the varnish and ease of desorption during baking, the temperature is preferably 80 to 230°C, and more preferably 120 to 180°C.

As the aryl sulfonate compound of formula (6), compounds of any of the following formulas (6-1) to (6-3) are preferred. 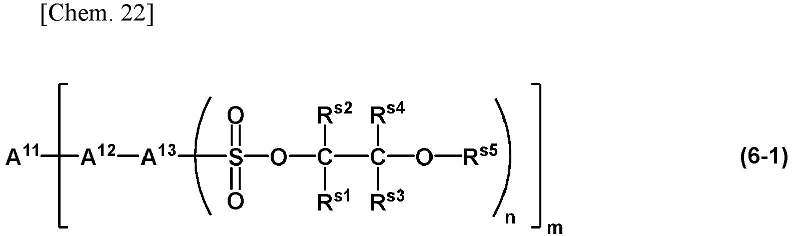 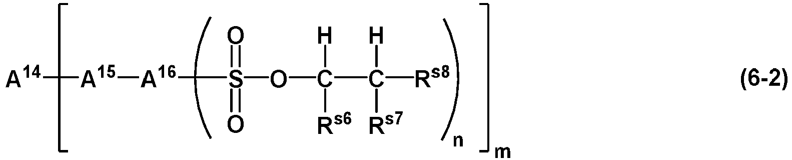 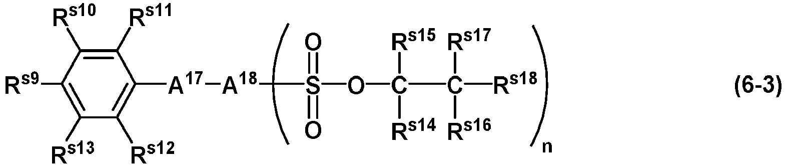 wherein m and n are the same as above.

In formula (6-1), A¹¹ is an m-valent group derived from perfluorobiphenyl. A¹² is -O- or S-, and -O- is preferred. A¹³ is a (n+1)-valent group derived from naphthalene or anthracene, and a group derived from naphthalene is preferred.

In formula (6-1), R^{s1} to R^{s4} are each independently a hydrogen atom or a linear or branched alkyl group of 1 to 6 carbon atoms, and R^{s5} is an optionally substituted monovalent hydrocarbon group of 2 to 20 carbon atoms.

Examples of the linear or branched alkyl group include, but are not particularly limited to, methyl, ethyl, n-propyl, isopropyl, n-butyl, isobutyl, tert-butyl, and n-hexyl groups. Of these, an alkyl group of 1 to 3 carbon atoms is preferred.

Examples of the monovalent hydrocarbon group of 2 to 20 carbon atoms include alkyl groups such as ethyl, n-propyl, isopropyl, n-butyl, isobutyl, and tert-butyl groups, and aryl groups such as phenyl, naphthyl, and phenanthryl groups.

Of R^{s1} to R^{s4}, it is preferable that R^{s1} or R^{s3} is a linear alkyl group of 1 to 3 carbon atoms, and the rest are hydrogen atoms. Further, it is preferable that R^{s1} is a linear alkyl group of 1 to 3 carbon atoms, and R^{s2} to R^{s4} are hydrogen atoms. The linear alkyl group of 1 to 3 carbon atoms is preferably a methyl group. Further, R^{s5} is preferably a linear alkyl group of 2 to 4 carbon atoms or a phenyl group.

In formula (6-2), A¹⁴ is an optionally substituted m-valent hydrocarbon group of 6 to 20 carbon atoms containing one or more aromatic rings. The hydrocarbon group is a group obtained by removing m hydrogen atoms from an m-valent hydrocarbon of 6 to 20 carbon atoms and containing one or more aromatic rings. Examples of the hydrocarbon include benzene, toluene, xylene, ethylbenzene, biphenyl, naphthalene, anthracene, and phenanthrene. In addition, in the hydrocarbon group, some or all of the hydrogen atoms may be further substituted with substituents, and examples of the substituent include the same as those described in the description of A¹. A¹⁴ is preferably the same as those described as a preferred example of A¹.

In formula (6-2), A¹⁵ is -O- or S-, and -O- is preferred.

In formula (6-2), A¹⁶ is a (n+1)-valent aromatic group of 6 to 20 carbon atoms. The aromatic group is a group obtained by removing (n+1) hydrogen atoms from an aromatic ring of an aromatic compound of 6 to 20 carbon atoms. Examples of the aromatic compound include benzene, toluene, xylene, biphenyl, naphthalene, anthracene, and pyrene. Of these, A¹⁶ is preferably a group derived from naphthalene or anthracene, and more preferably a group derived from naphthalene.

In formula (6-2), R^{s6} and R^{s7} are each independently a hydrogen atom or a linear or branched monovalent aliphatic hydrocarbon group. R^{s8} is a linear or branched monovalent aliphatic hydrocarbon group. However, the total carbon number of R^{s6}, R^{s7}, and R^{s8} is 6 or more. The upper limit of the total carbon number of R^{s6}, R^{s7}, and R^{s8} is not particularly limited, but is preferably 20 or less, and more preferably 10 or less.

Examples of the linear or branched monovalent aliphatic hydrocarbon group include, but are not particularly limited to, alkyl groups of 1 to 20 carbon atoms such as methyl, ethyl, n-propyl, isopropyl, n-butyl, isobutyl, tert-butyl, n-hexyl, n-octyl, 2-ethylhexyl, and decyl groups; and alkenyl group of 2 to 20 carbon atoms such as vinyl, 1-propenyl, 2-propenyl, isopropenyl, 1-methyl-2-propenyl, 1-butenyl, 2-butenyl, 3-butenyl, and hexenyl groups.

R^{s6} is preferably a hydrogen atom, and R^{s7} and R^{s8} are preferably alkyl groups of 1 to 6 carbon atoms. In this case, R^{s7} and R^{s8} may be the same or different.

In formula (6-2), m is an integer that satisfies 1 ≤ m ≤ 4, and is preferably 2. n is an integer that satisfies 1 ≤ n ≤ 4, and is preferably 2.

In formula (6-3), R^{s9} to R^{s13} are each independently a hydrogen atom, a nitro group, a cyano group, a halogen atom, an alkyl group of 1 to 10 carbon atoms, a halogenated alkyl group of 1 to 10 carbon atoms, or a halogenated alkenyl group of 2 to 10 carbon atoms.

The alkyl group of 1 to 10 carbon atoms may be linear, branched, or cyclic, and specific examples thereof include methyl, ethyl, n-propyl, isopropyl, n-butyl, isobutyl, sec-butyl, tert-butyl, n-pentyl, cyclopentyl, n-hexyl, cyclohexyl, n-heptyl, n-octyl, n-nonyl, and n-decyl groups.

The halogenated alkyl group of 1 to 10 carbon atoms is not particularly limited, so long as some or all of the hydrogen atoms of the alkyl group of 1 to 10 carbon atoms are substituted with halogen atoms. The halogenated alkyl group may be linear, branched, or cyclic, and specific examples thereof include trifluoromethyl, 2,2,2-trifluoroethyl, 1,1,2,2,2-perfluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl, and 1,1,2,2,3,3,4,4,4-nonafluorobutyl groups.

The halogenated alkenyl group of 2 to 10 carbon atoms is not particularly limited, so long as some or all of the hydrogen atoms of the alkenyl group of 2 to 10 carbon atoms are substituted with halogen atoms. Specific examples thereof include perfluorovinyl, perfluoro-1-propenyl, perfluoro-2-propenyl, perfluoro-1-butenyl, perfluoro-2-butenyl, and perfluoro-3-butenyl groups.

Of these, R^{s9} is preferably a nitro group, a cyano group, a halogenated alkyl group of 1 to 10 carbon atoms, a halogenated alkenyl group of 2 to 10 carbon atoms, or the like, more preferably a nitro group, a cyano group, a halogenated alkyl group of 1 to 4 carbon atoms, a halogenated alkenyl group of 2 to 4 carbon atoms, or the like, and even more preferably a nitro group, a cyano group, a trifluoromethyl group, a perfluoropropenyl group, or the like. Further, R^{s10} to R^{s13} are preferably halogen atoms, and more preferably fluorine atoms.

In formula (6-3), A¹⁷ is -O-, -S-, or NH-, and -O- is preferred.

In formula (6-3), A¹⁸ is a (n+1)-valent aromatic group of 6 to 20 carbon atoms. The aromatic group is a group obtained by removing (n+1) hydrogen atoms from an aromatic ring of an aromatic compound of 6 to 20 carbon atoms. Examples of the aromatic compound include benzene, toluene, xylene, biphenyl, naphthalene, anthracene, and pyrene. Of these, A¹⁸ is preferably a group derived from naphthalene or anthracene, and more preferably a group derived from naphthalene.

In formula (6-3), R^{s14} to R^{s17} are each independently a hydrogen atom or a linear or branched monovalent aliphatic hydrocarbon group of 1 to 20 carbon atoms.

Examples of the monovalent aliphatic hydrocarbon group include alkyl groups of 1 to 20 carbon atoms such as methyl, ethyl, n-propyl, isopropyl, n-butyl, isobutyl, sec-butyl, tert-butyl, n-pentyl, cyclopentyl, n-hexyl, cyclohexyl, n-heptyl, n-octyl, n-nonyl, n-decyl, n-undecyl, and n-dodecyl groups; and alkenyl group of 2 to 20 carbon atoms such as vinyl, 1-propenyl, 2-propenyl, isopropenyl, 1-methyl-2-propenyl, 1-butenyl, 2-butenyl, 3-butenyl, and hexenyl groups. Of these, the monovalent aliphatic hydrocarbon group is preferably an alkyl group of 1 to 20 carbon atoms, more preferably an alkyl group of 1 to 10 carbon atoms, and more preferably an alkyl group of 1 to 8 carbon atoms.

In formula (6-3), R^{s18} is a linear or branched monovalent aliphatic hydrocarbon group of 1 to 20 carbon atoms, or OR^{s19}. R^{s19} is an optionally substituted monovalent hydrocarbon group of 2 to 20 carbon atoms.

Examples of the linear or branched monovalent aliphatic hydrocarbon group of 1 to 20 carbon atoms of R^{s18} include the same ones as those mentioned above. When R^{s18} is a monovalent aliphatic hydrocarbon group, R^{s18} is preferably an alkyl group of 1 to 20 carbon atoms, more preferably an alkyl group of 1 to 10 carbon atoms, and even more preferably an alkyl group of 1 to 8 carbon atoms.

Examples of the monovalent hydrocarbon group of 2 to 20 carbon atoms of R^{s19} include the above-mentioned monovalent aliphatic hydrocarbon groups other than the methyl group, and aryl groups such as phenyl, naphthyl and phenanthryl groups. Of these, R^{s19} is preferably a linear alkyl group of 2 to 4 carbon atoms or a phenyl group. In addition, examples of the substituent in which the monovalent hydrocarbon group may have include a fluoro group, alkoxy groups of 1 to 4 carbon atoms, a nitro group, and a cyano group.

In formula (6-3), n is an integer that satisfies 1 ≤ n ≤ 4, and is preferably 2.

As the aryl sulfonate compound of formula (6-3), either of the following formula (6-3-1) or (6-3-2) is particularly preferred. 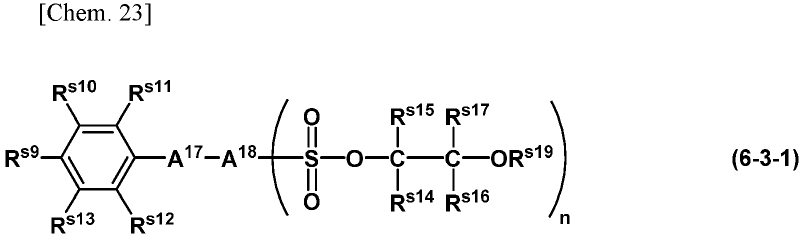 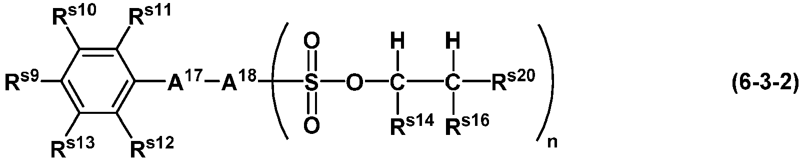 wherein A¹⁷, A¹⁸, R^{s9} to R^{s17}, R^{s19}, and n are the same as above. R^{s20} is a linear or branched monovalent aliphatic hydrocarbon group of 1 to 20 carbon atoms, and specific examples thereof include the same as those described in the description of R^{s18}.

In the aryl sulfonate compound of formula (6-3-1), it is preferable that R^{s14} or R^{s16} of R^{s14} to R^{s17} is a linear alkyl group of 1 to 3 carbon atoms, and the rest are hydrogen atoms. Further, it is preferable that R^{s14} is a linear alkyl group of 1 to 3 carbon atoms, and R^{s15} to R^{s17} are hydrogen atoms. The linear alkyl group of 1 to 3 carbon atoms is preferably a methyl group. Moreover, R^{s19} is preferably a linear alkyl group of 2 to 4 carbon atoms or a phenyl group.

In the aryl sulfonate compound of formula (6-3-2), the total carbon number of R^{s14}, R^{s16}, and R^{s20} is preferably 6 or more. The upper limit of the total carbon number of R^{s14}, R^{s16}, and R^{s20} is preferably 20 or less, and more preferably 10 or less. In this case, R^{s14} is preferably a hydrogen atom, and R^{s16} and R^{s20} are preferably alkyl groups of 1 to 6 carbon atoms. Moreover, R^{s16} and R^{s20} may be the same or different from each other.

The aryl sulfonate compounds of formulas (6) and (6') may be used singly, or two or more may be used in combination.

In addition, specific examples of suitable aryl sulfonates include, but are not limited to, those shown below.

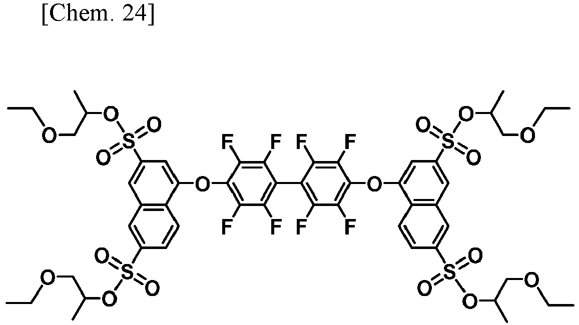

Also, when an aryl sulfonate is contained in the invention, the content thereof is, in a molar ratio, preferably about 0.01 to 20, and more preferably about 0.05 to 15, with respect to the charge-transporting substance 1.

Examples of the ionic compound may include metal salts and onium salts composed of an anion of the following formula (9a) or Z^{a} and its counter cation. 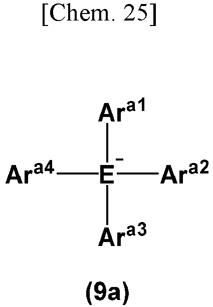 wherein E is an element belonging to Group 13 or Group 15 of the long periodic table, and Ar^{a1} to Ar^{a4} are each independently an aromatic hydrocarbon group which may have a substituent or an aromatic heterocyclic group which may have a substituent.

In formula (9a), E is preferably boron, gallium, phosphorus, or antimony among the elements belonging to Group 13 or Group 15 of the long periodic table, and more preferably boron.

In formula (9a), examples of the aromatic hydrocarbon group and aromatic heterocyclic group include monovalent groups derived from 5- or 6-membered monocyclic rings or 2 to 4 condensed rings. Of these, a monovalent group derived from a benzene ring, a naphthalene ring, a pyridine ring, a pyrazine ring, a pyridazine ring, a pyrimidine ring, a triazine ring, a quinoline ring, or an isoquinoline ring is preferred, in terms of stability and heat resistance of the compound.

Further, it is more preferable that at least one group of Ar^{a1} to Ar^{a4} has one or more fluorine atoms or chlorine atoms as substituents. In particular, a perfluoroaryl group in which all hydrogen atoms of Ar^{a1} to Ar^{a4} are substituted with fluorine atoms is most preferred. Specific examples of the perfluoroaryl group include a pentafluorophenyl group, a heptafluoro-2-naphthyl group, and a tetrafluoro-4-pyridyl group.

Examples of Z^{a} include ions of the following formula (9b), hydroxide ion, fluoride ion, chloride ion, bromide ion, iodide ion, cyanide ion, nitrate ion, nitrite ion, sulfate ion, sulfite ion, perchlorate ion, perbromate ion, periodate ion, chlorate ion, chlorite ion, hypochlorite ion, phosphate ion, phosphite ion, hypophosphite ion, borate ion, isocyanate ion, hydrosulfide ion, tetrafluoroborate ion, hexafluorophosphate ion, hexachloroantimonate ion; carboxylate ions such as acetate ion, trifluoroacetate ion, and benzoate ion; sulfonate ions such as methanesulfonate ion and trifluoromethanesulfonate ion; and alkoxy ions such as methoxy ions and t-butoxy ions.
[Chem. 26]

**E²X^{a}₆⁻** **9b**

wherein E² is an element belonging to Group 15 of the long periodic table, and X^{a} is a halogen atom such as a fluorine atom, a chlorine atom, or a bromine atom.

In formula (9b), E² is preferably a phosphorus atom, an arsenic atom, or an antimony atom, and is preferably a phosphorus atom, in terms of compound stability, ease of synthesis and purification, and toxicity.

X^{a} is preferably a fluorine atom or a chlorine atom, and most preferably a fluorine atom, in terms of stability of the compound, and ease of synthesis and purification.

On the other hand, as the counter cation, metal ions and onium ions can be preferably used.

The metal ion is preferably a monovalent metal ion, and examples thereof include Li⁺, Na⁺, K⁺, and Ag⁺, and Ag⁺ is particularly preferred.

Examples of the onium ion include iodonium ion, sulfonium ion, ammonium ion, and phosphonium ion, and an iodonium ion of the following formula (10) is particularly preferred.

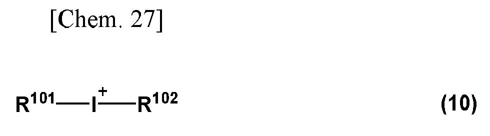

In formula (10), R¹⁰¹ and R¹⁰² are each independently an alkyl group of 1 to 12 carbon atoms, an alkenyl group of 2 to 12 carbon atoms, an alkynyl group of 2 to 12 carbon atoms, an aryl group of 6 to 20 carbon atoms, or a heteroaryl group of 2 to 20 carbon atoms, and may be substituted with a halogen atom, a cyano group, a nitro group, an alkyl group of 1 to 12 carbon atoms, an alkenyl group of 2 to 12 carbon atoms, an alkynyl group of 2 to 12 carbon atoms, an aryl group of 6 to 20 carbon atoms, or a heteroaryl group of 2 to 20 carbon atoms.

As the counter cation, further, an ion of the following formula (10') can also be used.

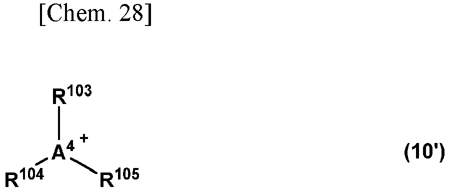

In formula (10'), A⁴ is an element of the third or subsequent period (third to sixth period) of the periodic table, which is an element belonging to Group 16 of the long periodic table. In the invention, of these, from the standpoint of electron accepting properties and availability, elements of the fifth period or earlier (third to fifth periods) of the periodic table are preferred. That is, as A⁴, any of a sulfur atom, a selenium atom, and a tellurium atom is preferred, and a sulfur atom is more preferred.

R¹⁰³ is an organic group bonded to A⁴ at a carbon atom, and R¹⁰⁴ and R¹⁰⁵ are each independently an arbitrary substituent. Two or more adjacent groups of R¹⁰³ to R¹⁰⁵ may be bonded to each other to form a ring.

The type of R¹⁰³ is not particularly limited, so long as it is an organic group having a carbon atom at the bonding portion with A⁴, as long as it does not deviate from the gist of the invention. The molecular weight of R¹⁰³, including its substituents, is usually in the range of 1,000 or less, and preferably 500 or less. Preferred examples of R¹⁰³ include an alkyl group, an alkenyl group, an alkynyl group, an aromatic hydrocarbon group, and an aromatic heterocyclic group, in terms of delocalizing positive charge. Of these, an aromatic hydrocarbon or aromatic heterocyclic group is preferred because it delocalizes the positive charge and is thermally stable.

The aromatic hydrocarbon group is a monovalent group derived from a 5- or 6-membered monocyclic ring or a 2 to 5 condensed ring, and includes a group capable of delocalizing the positive charge on the group. Specific examples thereof include monovalent groups derived from a benzene ring, a naphthalene ring, an anthracene ring, a phenanthrene ring, a perylene ring, a tetracene ring, a pyrene ring, a benzpyrene ring, a chrysene ring, a triphenylene ring, an acenaphthene ring, and a fluorene ring. More specifically, examples thereof include phenyl, tolyl, 1-naphthyl, 2-naphthyl, 1-anthryl, 2-anthryl, 9-anthryl, 1-phenanthryl, 2-phenanthryl, 3-phenanthryl, 4 phenanthryl, and 9-phenanthryl groups, phenyl and tolyl groups are preferred, and a tolyl group is more preferred.

The aromatic heterocyclic group is a monovalent group derived from a 5- or 6-membered monocyclic ring or a 2 to 4 condensed ring, and includes a group capable of delocalizing the positive charge on the group. Specific examples thereof include monovalent groups derived from a furan ring, a benzofuran ring, a thiophene ring, a benzothiophene ring, a pyrrole ring, a pyrazole ring, a triazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a shinoline ring, a quinoxaline ring, a phenanthridine ring, a benzimidazole ring, a pyrimidine ring, a quinazoline ring, a quinazolinone ring, and an azulene ring.

The alkyl group may be linear, branched, or cyclic, and examples thereof include those of usually 1 or more, and usually 12 or less and preferably 6 or less carbon atoms. Specific examples thereof include methyl, ethyl, n-propyl, 2-propyl, n-butyl, isobutyl, tert-butyl, and cyclohexyl groups.

Examples of the alkenyl group include those of usually 2 or more, usually 12 or less and preferably 6 or less carbon atoms. Specific examples thereof include vinyl, allyl, and 1-butenyl groups.

Examples of the alkynyl group include those of usually 2 or more, usually 12 or less and preferably 6 or less carbon atoms. Specific examples thereof include ethynyl and propargyl groups.

R¹⁰⁴ and R¹⁰⁵ are not particularly limited, as long as it does not deviate from the gist of the invention. The molecular weights of R¹⁰⁴ and R¹⁰⁵, including the substituents, are each usually in the range of 1,000 or less, and preferably 500 or less. Examples of R¹⁰⁴ and R¹⁰⁵ include alkyl groups, alkenyl groups, alkynyl groups, aromatic hydrocarbon groups, aromatic heterocyclic groups, amino groups, alkoxy groups, aryloxy groups, acyl groups, alkoxycarbonyl groups, aryloxycarbonyl groups, alkylcarbonyloxy groups, alkylthio groups, arylthio groups, sulfonyl groups, alkylsulfonyl groups, arylsulfonyl groups, cyano groups, hydroxyl groups, thiol groups, and silyl groups. Of these, similarly to R¹⁰³, in terms of having large electron accepting properties, organic groups having a carbon atom at the bonding portion with A⁴ are preferred, and alkyl groups, alkenyl groups, alkynyl groups, aromatic hydrocarbon groups, and aromatic heterocyclic groups are preferred. In particular, an aromatic hydrocarbon group or an aromatic heterocyclic group is preferred because it has large electron accepting properties and is thermally stable.

Examples of the alkyl group, alkenyl group, alkynyl group, aromatic hydrocarbon group, and aromatic heterocyclic group are the same as those described above for R¹⁰³.

Examples of the amino group include alkylamino, arylamino, and acylamino groups. Examples of the alkylamino group include alkylamino groups having one or more alkyl groups having usually 1 or more, and usually 12 or less and preferably 6 or less carbon atoms. Specific examples thereof include methylamino, dimethylamino, diethylamino, and dibenzylamino groups.

Examples of the arylamino group include arylamino groups having one or more aromatic hydrocarbon groups or aromatic heterocyclic groups of usually 3 or more and preferably 4 or more, and usually 25 or less and preferably 15 or less carbon atoms. Specific examples thereof include phenylamino, diphenylamino, tolylamino, pyridylamino, and thienylamino groups.

Examples of the acylamino group include acylamino groups having one or more acyl groups of usually 2 or more, and usually 25 or less and preferably 15 or less carbon atoms. Specific examples thereof include acetylamino and benzoylamino groups.

Examples of the alkoxy group include alkoxy groups of usually 1 or more, and usually 12 or less and preferably 6 or less carbon atoms. Specific examples include methoxy, ethoxy, and butoxy groups.

Examples of the aryloxy group include aryloxy groups having an aromatic hydrocarbon group or an aromatic heterocyclic group of usually 3 or more and preferably 4 or more, and usually 25 or less and preferably 15 or less carbon atoms. Specific examples include phenyloxy, naphthyloxy, pyridyloxy, and thienyloxy groups.

Examples of the acyl group include acyl groups of usually 1 or more, and usually 25 or less and preferably 15 or less carbon atoms. Specific examples include formyl, acetyl and benzoyl groups.

Examples of the alkoxycarbonyl group include alkoxycarbonyl groups of usually 2 or more, and usually 10 or less and preferably 7 or less carbon atoms. Specific examples include methoxycarbonyl and ethoxycarbonyl groups.

Examples of the aryloxycarbonyl group include those having an aromatic hydrocarbon group or an aromatic heterocyclic group of usually 3 or more and preferably 4 or more, and usually 25 or less and preferably 15 or less carbon atoms. Specific examples include phenoxycarbonyl and pyridyloxycarbonyl groups.

Examples of the alkylcarbonyloxy group include alkylcarbonyloxy groups of usually 2 or more, and usually 10 or less and preferably 7 or less carbon atoms. Specific examples include acetoxy and trifluoroacetoxy groups.

Examples of the alkylthio group include alkylthio groups of usually 1 or more, and usually 12 or less and preferably 6 or less carbon atoms. Specific examples include methylthio and ethylthio groups.

Examples of the arylthio group include arylthio groups of usually 3 or more and preferably 4 or more, and usually 25 or less and preferably 14 or less carbon atoms. Specific examples include phenylthio, naphthylthio, and pyridylthio groups.

Specific examples of the alkylsulfonyl group and the arylsulfonyl group include mesyl and tosyl groups.

Specific examples of the sulfonyloxy group include mesyloxy and tosyloxy groups.

Specific examples of the silyl group include trimethylsilyl and triphenylsilyl groups.

As described above, the groups exemplified as R¹⁰³, R¹⁰⁴, and R¹⁰⁵ may be further substituted with other substituents, as long as it does not deviate from the gist of the invention. The type of the substituent is not particularly limited, and examples thereof include the groups exemplified as R¹⁰³, R¹⁰⁴, and R¹⁰⁵, as well as halogen atoms, cyano, thiocyano, and nitro groups. Of these, an alkyl group, an alkenyl group, an alkynyl group, an alkoxy group, an aryloxy group, an aromatic hydrocarbon group, or an aromatic heterocyclic group is preferred, from the standpoint of not hindering the heat resistance and electron accepting properties of the ionic compound (electron-accepting ionic compound).

Of these described above, ionic compounds which are combinations of an anion and a cation of the following formulas (11) to (14) (see JP 5381931 B2) can be preferably used.

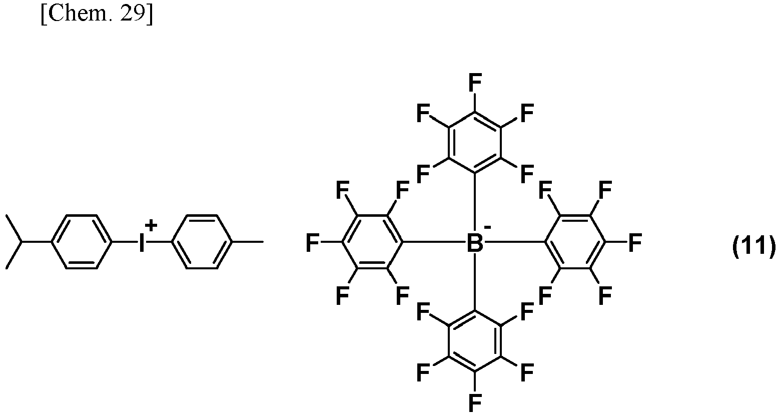

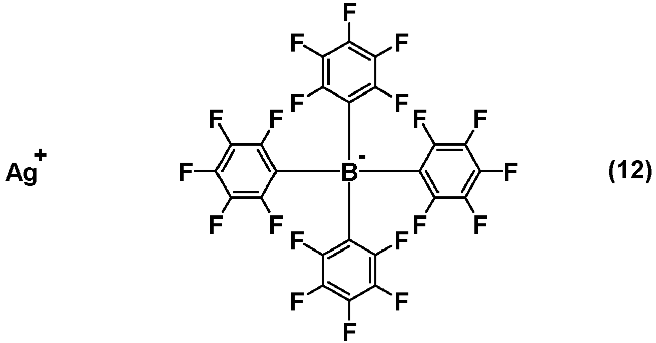

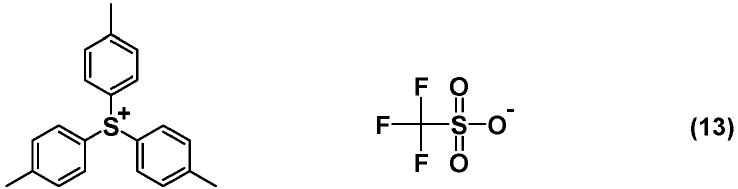

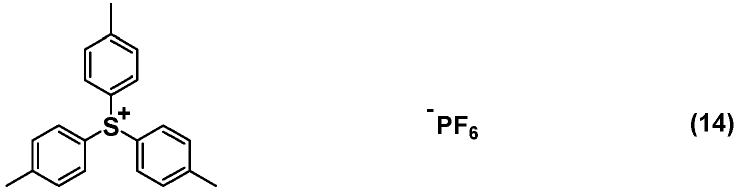

Furthermore, onium borate salts (provided that it is an electrically neutral salt) consisting of a monovalent or divalent anion of formula (a1) and counter cations of formulas (c1) to (c5) also can be preferably used. 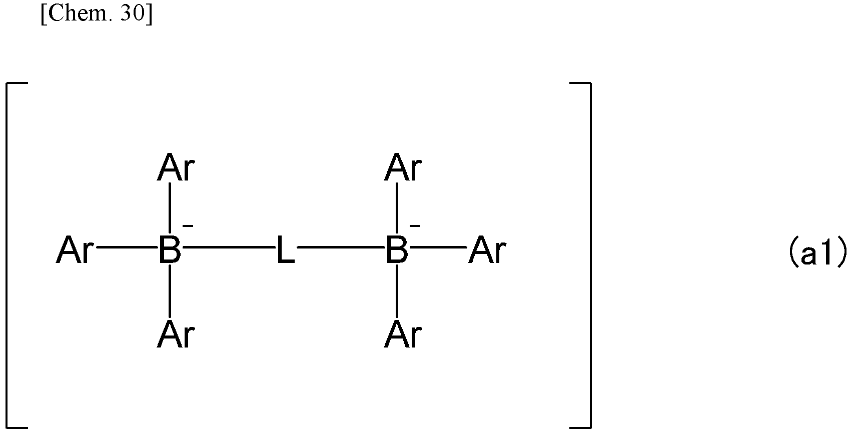 wherein Ars are each independently an aryl group which may have a substituent or a heteroaryl group which may have a substituent, and L is an alkylene group, -NH-, an oxygen atom, a sulfur atom, or -CN⁺-.

Examples of the aryl group include aryl groups of 6 to 20 carbon atoms. Specific examples thereof include phenyl, tolyl, 1-naphthyl, 2-naphthyl, 1-anthryl, 2-anthryl, 9-anthryl, 1-phenanthryl, 2-phenanthryl, 3-phenanthryl, 4-phenanthryl, and 9-phenanthryl groups, and phenyl, tolyl, and naphthyl groups are preferred.

Examples of the substituent include halogen atoms, a nitro group, a cyano group, alkyl groups of 1 to 20 carbon atoms, alkenyl groups of 2 to 20 carbon atoms, and alkynyl groups of 2 to 20 carbon atoms.

Examples of the halogen atom include a fluorine atom, a chlorine atom, a bromine atom, and an iodine atom, and a fluorine atom is preferred.

The alkyl group of 1 to 20 carbon atoms may be linear, branched, or cyclic, and specific examples thereof include methyl, ethyl, n-propyl, isopropyl, n-butyl, isobutyl, s-butyl, t-butyl, n-pentyl, n-hexyl, n-heptyl, n-octyl, n-nonyl, n-decyl, n-undecyl, n-dodecyl, n-tridecyl, n-tetradecyl, n-pentadecyl, n-hexadecyl, n-heptadecyl, n-octadecyl, n-nonadecyl, and n-eicosanyl groups, and alkyl groups of 1 to 18 carbon atoms are preferred, and alkyl groups of 1 to 8 carbon atoms are more preferred.

Specific examples of the alkenyl group of 2 to 20 carbon atoms include ethenyl, n-1-propenyl, n-2-propenyl, 1-methylethenyl, n-1-butenyl, n-2-butenyl, n-3-butenyl, 2-methyl-1-propenyl, 2-methyl-2-propenyl, 1-ethylethenyl, 1-methyl-1-propenyl, 1-methyl-2-propenyl, n-1-pentenyl, n-1-decenyl, and n-1-eicosenyl groups.

Specific examples of the alkynyl group of 2 to 20 carbon atoms include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-pentynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl, and n-1-eicosinyl groups.

Further, of the substituents described above, the aryl groups having one or more electron withdrawing groups are preferred. Examples of the electron withdrawing group include halogen atoms, a nitro group, and a cyano group, and halogen atoms are preferred, and a fluorine atom is particularly preferred.

Examples of the heteroaryl group preferably include heteroaryl groups of 2 to 20 carbon atoms. Specific examples thereof include oxygen-containing heteroaryl groups such as 2-thienyl, 3-thienyl, 2-furanyl, 3-furanyl, 2-oxazolyl, 4-oxazolyl, 5-oxazolyl, 3-isooxazolyl, 4-isooxazolyl, and 5-isooxazolyl groups, sulfur-containing heteroaryl groups such as 2-thiazolyl, 4-thiazolyl, 5-thiazolyl, 3-isothiazolyl, 4-isothiazolyl, and 5-isothiazolyl groups, and nitrogen-containing heteroaryl groups such as 2-imidazolyl, 4-imidazolyl, 2-pyridyl, 3-pyridyl, 4-pyridyl, 2-pyrazyl, 3-pyrazyl, 5-pyrazyl, 6-pyrazyl, 2-pyrimidyl, 4-pyrimidyl, 5-pyrimidyl, 6-pyrimidyl, 3-pyridazyl, 4-pyridazyl, 5-pyridazyl, 6-pyridazyl, 1,2,3-triazin-4-yl, 1,2,3-triazin-5-yl, 1,2,4-triazin-3-yl, 1,2,4-triazin-5-yl, 1,2,4-triazin-6-yl, 1,3,5-triazin-2-yl, 1,2,4,5-tetrazin-3-yl, 1,2,3,4-tetrazin-5-yl, 2-quinolinyl, 3-quinolinyl, 4-quinolinyl, 5-quinolinyl, 6-quinolinyl, 7-quinolinyl, 8-quinolinyl, 1-isoquinolinyl, 3-isoquinolinyl, 4-isoquinolinyl, 5-isoquinolinyl, 6-isoquinolinyl, 7-isoquinolinyl, 8-isoquinolinyl, 2-quinoxanyl, 5-quinoxanyl, 6-quinoxanyl, 2-quinazolinyl, 4-quinazolinyl, 5-quinazolinyl, 6-quinazolinyl, 7-quinazolinyl, 8-quinazolinyl, 3-cinnolinyl, 4-cinnolinyl, 5-cinnolinyl, 6-cinnolinyl, 7-cinnolinyl, and 8-cinnolinyl groups.

Examples of the substituent of the heteroaryl group include the same substituents as those exemplified for the aryl group.

L is an alkylene group, -NH-, an oxygen atom, a sulfur atom, or -CN⁺-, and -CN⁺-is preferred.

The alkylene group may be linear, branched, or cyclic, and examples thereof include alkylene groups of 1 to 20 carbon atoms, and preferably 1 to 10 carbon atoms. Specific examples thereof include methylene, methylmethylene, dimethylmethylene, ethylene, trimethylene, propylene, tetramethylene, pentamethylene, and hexamethylene groups.

Examples of the anion of the above formula (a1) that can be preferably used in the invention include those of formula (a2), but are not limited thereto.

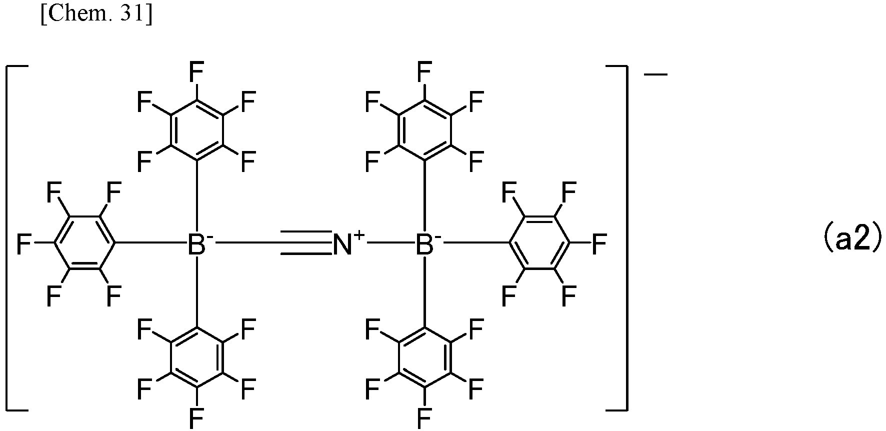

On the other hand, examples of the counter cation include those of formulas (c1) to (c5).

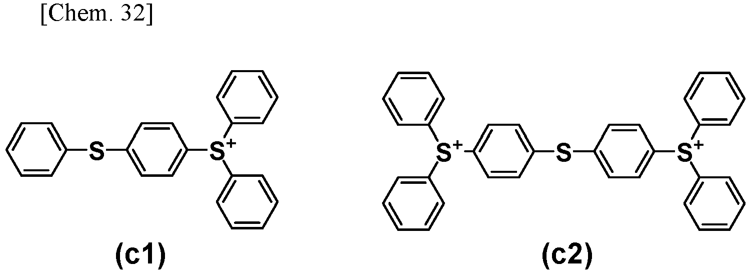

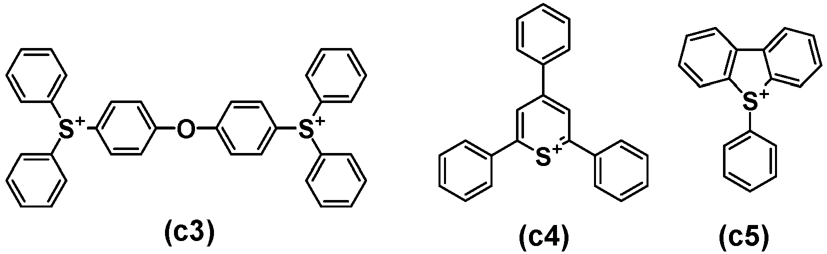

In the invention, the onium borate salts may be used singly, or two or more may be used in combination.

Moreover, other known onium borate salts may be used together as necessary.

The onium borate salt can be synthesized with reference to a known method described in, for example, JP 2005-314682 A.

The onium borate salt may be previously dissolved in an organic solvent in order to facilitate dissolution in the charge-transporting varnish.

Such organic solvents include carbonates such as propylene carbonate, ethylene carbonate, 1,2-butylene carbonate, dimethyl carbonate, and diethyl carbonate; ketones such as acetone, methyl ethyl ketone, cyclohexanone, methyl isoamyl ketone, and 2-heptanone; polyhydric alcohols such as monomethyl ether, monoethyl ether, monopropyl ether, monobutyl ether, or monophenyl ether of ethylene glycol, ethylene glycol monoacetate, diethylene glycol, diethylene glycol monoacetate, propylene glycol, propylene glycol monoacetate, dipropylene glycol, and dipropylene glycol monoacetate, and their derivatives; cyclic ethers such as dioxane; esters such as ethyl formate, methyl lactate, ethyl lactate, methyl acetate, ethyl acetate, butyl acetate, methyl pyruvate, methyl acetoacetate, ethyl acetoacetate, ethyl pyruvate, ethyl ethoxyacetate, methyl methoxypropionate, ethyl ethoxypropionate, methyl 2-hydroxypropionate, ethyl 2-hydroxypropionate, ethyl 2-hydroxy-2-methylpropionate, methyl 2-hydroxy-3-methylbutanoate, 3-methoxybutyl acetate, and 3-methyl-3-methoxybutyl acetate; and aromatic hydrocarbons such as toluene, xylene, 3-phenoxytoluene, 4-methoxytoluene, methyl benzoate, cyclohexylbenzene, tetralin, and isophorone, and these may be used singly, or two or more may be used in combination.

When an organic solvent is used, its use ratio is preferably 15 to 1,000 parts by weight, and more preferably 30 to 500 parts by weight, per 100 parts by weight of the onium borate salt.

Specific examples of the tetracyanoquinodimethane derivative include tetrafluoroquinodimethanes such as 7,7,8,8-tetracyanoquinodimethane (TCNQ) and 2-fluoro-7,7,8,8-tetracyanoquinodimethane and 2,5-difluoro-7,7,8,8-tetracyanoquinodimethane, and halotetracyanoquinodimethanes (halo TCNQ) such as tetrafluoro-7,7,8,8-tetracyanoquinodimethane.

Specific examples of the benzoquinone derivative include tetrafluoro-1,4-benzoquinone, tetrachloro-1,4-benzoquinone (chloranil), and 2,3-dichloro-5,6-dicyano-1,4-benzoquinone (DDQ).

These inorganic and organic dopant substances may be used singly, or two or more may be used in combination.

In addition, examples of the halotetracyanoquinodimethane compound include compounds of formula (15). 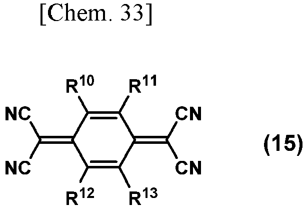 wherein R¹⁰ to R¹³ are each independently a hydrogen atom or a halogen atom, but at least one is a halogen atom, preferably at least two are halogen atoms, and more preferably at least three are halogen atoms, and most preferably all are halogen atoms.

Examples of the halogen atom include the same ones as described above, but a fluorine atom or a chlorine atom is preferred, and a fluorine atom is more preferred.

Specific examples of the halotetracyanoquinodimethane compound include tetrafluorotetracyanoquinodimethane (F4TCNQ), tetrachlorotetracyanoquinodimethane, 2-fluorotetracyanoquinodimethane, 2-chlorotetracyanoquinodimethane, 2,5-difluorotetracyanoquinodimethane, and 2,5-dichlorotetracyanoquinodimethane, but in the invention, F4TCNQ is most suitable.

The content of the halotetracyanoquinodimethane compound in the charge-transporting varnish of the invention is preferably 0.0001 to 50 equivalents, more preferably 0.001 to 20 equivalents, and further preferably 0.01 to 10 equivalents, with respect to the aniline derivative.

Further, when the obtained thin film is used as a hole-injecting layer of an organic EL device, in consideration of obtaining a device having a long life with good reproducibility, it is preferable that the charge-transporting varnish of the invention contains an organosilane compound.

Examples of the organosilane compound include dialkoxysilane compounds, trialkoxysilane compounds, and tetraalkoxysilane compounds, and these may be used singly, or two or more may be used in combination.

Especially, as the organosilane compound, a dialkoxysilane compound or a trialkoxysilane compound is preferred, and a trialkoxysilane compound is more preferred.

Examples of these alkoxysilane compounds include those of formulas (16) to (18).

Si(OR)₄ (16)

SiR'(OR)₃ (17)

Si(R')₂(OR)₂ (18)

wherein Rs are each independently an alkyl group of 1 to 20 carbon atoms optionally substituted with Z¹, an alkenyl group of 2 to 20 carbon atoms optionally substituted with Z¹, an alkynyl group of 2 to 20 carbon atoms substituted with Z¹, an aryl group of 6 to 20 carbon atoms optionally substituted with Z², or a heteroaryl group of 2 to 20 carbon atoms optionally substituted with Z², and R's are each independently an alkyl group of 1 to 20 carbon atoms optionally substituted with Z³, an alkenyl group of 2 to 20 carbon atoms optionally substituted with Z³, an alkynyl group of 2 to 20 carbon atoms optionally substituted with Z³, an aryl group of 6 to 20 carbon atoms optionally substituted with Z⁴, or a heteroaryl group of 2 to 20 carbon atoms optionally substituted with Z⁴.

Z¹ is a halogen atom, an aryl group of 6 to 20 carbon atoms optionally substituted with Z⁵, or a heteroaryl group of 2 to 20 carbon atoms optionally substituted with Z⁵, and Z² is a halogen atom, an alkyl group of 1 to 20 carbon atoms optionally substituted with Z⁵, an alkenyl group of 2 to 20 carbon atoms optionally substituted with Z⁵, or an alkynyl group of 2 to 20 carbon atoms optionally substituted with Z⁵.

Z³ is a halogen atom, an aryl group of 6 to 20 carbon atoms optionally substituted with Z⁵, a heteroaryl group of 2 to 20 carbon atoms optionally substituted with Z⁵, an epoxycyclohexyl group, a glycidoxy group, a methacryloxy group, an acryloxy group, an ureido group (-NHCONH₂), a thiol group, an isocyanate group (-NCO), an amino group, a -NHY¹ group, or a -NY²Y³ group, Z⁴ is a halogen atom, an alkyl group of 1 to 20 carbon atoms optionally substituted with Z⁵, an alkenyl group of 2 to 20 carbon atoms optionally substituted with Z⁵, an alkynyl group of 2 to 20 carbon atoms optionally substituted with Z⁵, an epoxycyclohexyl group, a glycidoxy group, a methacryloxy group, an acryloxy group, an ureido group (-NHCONH2), a thiol group, an isocyanate group (-NCO), an amino group, a -NHY¹ group, or a -NY²Y³ group, and Y¹ to Y³ are each independently an alkyl group of 1 to 20 carbon atoms optionally substituted with Z⁵, an alkenyl group of 2 to 20 carbon atoms optionally substituted with Z⁵, an alkynyl group of 2 to 20 carbon atoms optionally substituted with Z⁵, an aryl group of 6 to 20 carbon atoms optionally substituted with Z⁵, or a heteroaryl group of 2 to 20 carbon atoms optionally substituted with Z⁵.

Z⁵ is a halogen atom, an amino group, a nitro group, a cyano group, or a thiol group.

Examples of the halogen atom, alkyl group of 1 to 20 carbon atoms, alkenyl group of 2 to 20 carbon atoms, alkynyl group of 2 to 20 carbon atoms, aryl group of 6 to 20 carbon atoms, and heteroaryl group of 2 to 20 carbon atoms in formulas (16) to (18) include the same as those exemplified in the description of the above formula (a1).

In R and R', the carbon number of the alkyl group, alkenyl group, and alkynyl group is preferably 10 or less, more preferably 6 or less, and even more preferably 4 or less.

Further, the carbon number of the aryl group and heteroaryl group is preferably 14 or less, more preferably 10 or less, and even more preferably 6 or less.

R is preferably an alkyl group of 1 to 20 carbon atoms or alkenyl group of 2 to 20 carbon atoms optionally substituted with Z¹ or an aryl group of 6 to 20 carbon atoms optionally substituted with Z², more preferably an alkyl group of 1 to 6 carbon atoms or alkenyl group of 2 to 6 carbon atoms optionally substituted with Z¹ or a phenyl group optionally substituted with Z², even more preferably an alkyl group of 1 to 4 carbon atoms optionally substituted with Z² or a phenyl group optionally substituted with Z², and further preferably a methyl group or ethyl group optionally substituted with Z¹.

Further, R' is preferably an alkyl group of 1 to 20 carbon atoms optionally substituted with Z³ or an aryl group of 6 to 20 carbon atoms optionally substituted with Z⁴, more preferably an alkyl group of 1 to 10 carbon atoms optionally substituted with Z³ or an aryl group of 6 to 14 carbon atoms optionally substituted with Z⁴, even more preferably an alkyl group of 1 to 6 carbon atoms optionally substituted with Z³, or an aryl group of 6 to 10 carbon atoms optionally substituted with Z⁴, and further preferably an alkyl group of 1 to 4 carbon atoms optionally substituted with Z³ or a phenyl group optionally substituted with Z⁴.

It should be noted that a plurality of Rs may be the same or different, and a plurality of R's may be also the same or different.

Z¹ is preferably a halogen atom or an aryl group of 6 to 20 carbon atoms optionally substituted with Z⁵, and more preferably a fluorine atom or a phenyl group optionally substituted with Z⁵, and most suitably, Z¹ does not exist (e.g., is unsubstituted).

Further, Z² is preferably a halogen atom or an alkyl group of 6 to 20 carbon atoms optionally substituted with Z⁵, and more preferably a fluorine atom or an alkyl group of 1 to 10 carbon atoms optionally substituted with Z⁵, and most suitably, Z² does not exist (e.g., is unsubstituted).

On the other hand, Z³ is preferably a halogen atom, a phenyl group optionally substituted with Z⁵, a furanyl group optionally substituted with Z⁵, an epoxycyclohexyl group, a glycidoxy group, a methacryloxy group, an acryloxy group, a ureido group, a thiol group, an isocyanate group, an amino group, a phenylamino group optionally substituted with Z⁵, or a diphenylamino group optionally substituted with Z⁵, more preferably a halogen atom, and even more preferably, a fluorine atom, or Z³ does not exist (e.g., is unsubstituted).

In addition, Z⁴ is preferably a halogen atom, an alkyl group of 1 to 20 carbon atoms optionally substituted with Z⁵, a furanyl group optionally substituted with Z⁵, an epoxycyclohexyl group, a glycidoxy group, a methacryloxy group, an acryloxy group, a ureido group, a thiol group, an isocyanate group, an amino group, a phenylamino group optionally substituted with Z⁵, or a diphenylamino group optionally substituted with Z⁵, more preferably a halogen atom, and even more preferably, a fluorine atom, or Z⁴ does not exist (e.g., is unsubstituted).

Moreover, Z⁵ is preferably a halogen atom, and more preferably a fluorine atom, or Z⁵ does not exist (e.g., is unsubstituted).

Specific examples of organosilane compound that can be used in the invention are given below, but are not limited thereto.

Specific examples of the dialkoxysilane compound include dimethyldimethoxysilane, dimethyldiethoxysilane, methyl ethyl dimethoxysilane, diethyldimethoxysilane, diethyl diethoxysilane, methylpropyldimethoxysilane, methylpropyldiethoxysilane, diisopropyldimethoxysilane, phenylmethyldimethoxysilane, vinylmethyldimethoxysilane, 3-glycidoxypropylmethyldimethoxysilane, 3-glycidoxypropylmethyldiethoxysilane, 3-(3,4-epoxycyclohexyl)ethylmethyldimethoxysilane, 3-methacryloxypropylmethyldimethoxysilane, 3-methacryloxypropylmethyldiethoxysilane, 3-mercaptopropylmethyldimethoxysilane, γ-aminopropylmethyldiethoxysilane, N-(2-aminoethyl)aminopropylmethyldimethoxysilane, and 3,3,3-trifluoropropylmethyldimethoxysilane.

Specific examples of the trialkoxysilane compound include methyltrimethoxysilane, methyltriethoxysilane, ethyltrimethoxysilane, ethyltriethoxysilane, propyltrimethoxysilane, propyltriethoxysilane, butyltrimethoxysilane, butyltriethoxysilane, pentyltrimethoxysilane, pentyltriethoxysilane, heptyltrimethoxysilane, heptyltriethoxysilane, octyltrimethoxysilane, octyltriethoxysilane, dodecyltrimethoxysilane, dodecyltriethoxysilane, hexadecyltrimethoxysilane, hexadecyltriethoxysilane, octadecyltrimethoxysilane, octadecyltriethoxysilane, phenyltrimethoxysilane, phenyltriethoxysilane, vinyltrimethoxysilane, vinyltriethoxysilane, 3-aminopropyltrimethoxysilane, 3-aminopropyltriethoxysilane, 3-glycidoxypropyltrimethoxysilane, 3-glycidoxypropyltriethoxysilane, 3-methacryloxypropyltrimethoxysilane, 3-methacryloxypropyltriethoxysilane, triethoxy(4-(trifluoromethyl)phenyl)silane, dodecyltriethoxysilane, 3,3,3-trifluoropropyltrimethoxysilane, (triethoxysilyl)cyclohexane, perfluorooctylethyltriethoxysilane, triethoxyfluorosilane, tridecafluoro-1,1,2,2-tetrahydrooctyltriethoxysilane, pentafluorophenyltrimethoxysilane, pentafluorophenyltriethoxysilane, 3-(heptafluoroisopropoxy)propyltriethoxysilane, heptadecafluoro-1,1,2,2-tetrahydrodecyltriethoxysilane, triethoxy-2-thienylsilane, and 3-(triethoxysilyl)furan.

Specific examples of the tetraalkoxysilane compound include tetraethoxysilane, tetramethoxysilane, and tetrapropoxysilane.

Of these, 3,3,3-trifluoropropylmethyldimethoxysilane, triethoxy(4-(trifluoromethyl)phenyl)silane, 3,3,3-trifluoropropyltrimethoxysilane, perfluorooctylethyltriethoxysilane, pentafluorophenyltrimethoxysilane, and pentafluorophenyltriethoxysilane are preferred.

When the charge-transporting varnish of the invention contains an organosilane compound, the content thereof, based on the total weight of the charge-transporting substance and the dopant substance, is usually about 0.1 to 50% by weight. However, to suppress a decrease in the charge transportability of the resulting thin film and also increase the ability to inject holes into a layer laminated so as to be in contact with the above-described hole-injecting layer on the cathode side, the content is preferably about 0.5 to 40% by weight, more preferably about 0.8 to 30% by weight, and even more preferably about 1 to 20% by weight.

In the charge-transporting varnish of the invention, in addition to the charge-transporting substance consisting of the above-described aniline derivative, other known charge-transporting substances can also be used.

As the organic solvent used when preparing the charge-transporting varnish of the invention, a highly soluble solvent which are capable of dissolving well the aniline derivative of the invention can be used. In order to dissolve the aniline derivative having no substituent on the nitrogen atom of the carbazole group, it is necessary to include at least one kind of highly polar solvent. On the other hand, the aniline derivative having a predetermined silyl group on the nitrogen atom of the carbazole group of the invention can be dissolved in a solvent regardless of the polarity of the solvent. Moreover, if necessary, a low polar solvent may be used because it has better process compatibility than the highly polar solvent. In the invention, a low polar solvent is defined as a solvent having a relative dielectric constant of less than 7 at a frequency of 100 kHz, and a highly polar solvent is defined as a solvent having a relative dielectric constant of 7 or more at a frequency of 100 kHz.

Examples of the low polar solvent include
chlorine solvents such as chloroform and chlorobenzene;
aromatic hydrocarbon solvents such as toluene, xylene, tetralin, cyclohexylbenzene, and decylbenzene;
aliphatic alcohol solvents such as 1-octanol, 1-nonanol, and 1-decanol;
ether solvents such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, and triethylene glycol butyl methyl ether; and
ester solvents such as methyl benzoate, ethyl benzoate, butyl benzoate, isoamyl benzoate, bis(2-ethylhexyl) phthalate, dibutyl maleate, dibutyl oxalate, hexyl acetate, diethylene glycol monoethyl ether acetate, and diethylene glycol monobutyl ether acetate.

Further, examples of the highly polar solvent include
amide solvents such as N,N-dimethylformamide, N,N-dimethylacetamide, N,N-dimethylisobutylamide, N-methylpyrrolidone, and 1,3-dimethyl-2-imidazolidinone;
ketone solvents such as ethyl methyl ketone, isophorone, and cyclohexanone;
cyano solvents such as acetonitrile and 3-methoxypropionitrile;
polyhydric alcohol solvents such as ethylene glycol, diethylene glycol, triethylene glycol, dipropylene glycol, 1,3-butanediol, and 2,3-butanediol;
monohydric alcohol solvents other than aliphatic alcohols such as diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol; and
sulfoxide solvents such as dimethyl sulfoxide.

A charge-transporting thin film can be formed on a substrate by applying the charge-transporting varnish described above onto the substrate and baking it.

The coating method of the varnish is not particularly limited, and examples thereof include dipping, spin coating, transfer printing, roll coating, brush coating, inkjet printing, and spraying. It is preferable to adjust viscosity and surface tension of the varnish depending on the coating method.

When using the varnish of the invention, the baking atmosphere is not also particularly limited, and a thin film having a uniform film forming face and high charge transportability can be obtained not only in an open-air atmosphere, but even in an inert gas such as nitrogen or in a vacuum.

The baking temperature is suitably set in the range of about 100 to 260°C while taking into consideration the intended use of the resulting thin film, the degree of charge transportability to be imparted to the resulting thin film, the type and boiling point of the solvent, and the like. When the resulting thin film is used as a hole-injecting layer in an organic EL device, the baking temperature is preferably about 140 to 250°C, and more preferably about 145 to 240°C.

It should be noted that, during baking, a temperature change in two or more steps may be applied for the purposes of achieving more uniform film formability and proceeding the reaction on the substrate. Heating may be carried out using a suitable apparatus such as a hot plate or an oven.

The film thickness of the charge-transporting thin film is not particularly limited, but when used as a hole-injecting layer in an organic EL device, it is preferably 5 to 200 nm. As a method of changing the film thickness, there are a method of changing a solid content concentration in a varnish, and a method of changing a solution amount on a substrate at the time of application.

The materials and method for fabricating an OLED device using the charge-transporting varnish of the invention are exemplified by those mentioned below, but are not limited thereto.

The electrode substrate to be used is preferably cleaned beforehand by liquid washing with, for example, a cleaning agent, alcohol, or pure water. For example, an anode substrate is preferably subjected to surface treatment such as UV/ozone treatment or oxygen-plasma treatment just prior to use. However, surface treatment may not be carried out when the anode material contains organic matter as a principal component.

A method for fabricating an OLED device having a hole-injecting layer consisting of a thin film obtained from the charge-transporting varnish of the invention is as follows.

A hole-injecting layer is produced on an electrode by applying the charge-transporting varnish of the invention onto an anode substrate and baking it by the method described above. This is introduced into a vacuum deposition system, and a hole-transporting layer, light-emitting layer, electron-transporting layer, electron-transporting layer/hole-blocking layer, and cathode metal are sequentially vapor-deposited to obtain an OLED device. If necessary, an electron-blocking layer may be provided between the light-emitting layer and the hole-transporting layer.

Examples of the anode material include transparent electrodes typified by indium-tin oxide (ITO) and indium-zinc oxide (IZO), and metal anodes made of a metal typified by aluminum or an alloy thereof, and an anode material on which planarizing treatment has been carried out is preferred. A polythiophene derivative or polyaniline derivative having high charge transportability can also be used.

The other metals constituting the metal anode include scandium, titanium, vanadium, chromium, manganese, iron, cobalt, nickel, copper, zinc, gallium, yttrium, zirconium, niobium, molybdenum, ruthenium, rhodium, palladium, cadmium, indium, scandium, lanthanum, cerium, praseodymium, neodymium, promethium, samarium, europium, gadolinium, terbium, dysprosium, holmium, erbium, thulium, ytterbium, hafnium, thallium, tungsten, rhenium, osmium, iridium, platinum, gold, titanium, lead, bismuth, and alloys thereof, but are not limited thereto.

Examples of materials for forming the hole-transporting layer include triarylamines such as (triphenylamine) dimer derivatives, [(triphenylamine) dimer] spirodimer, N,N'-bis(naphthalen-1-yl)-N,N'-bis(phenyl)-benzidine (α-NPD), N,N'-bis(naphthalen-2-yl)-N,N'-bis(phenyl)-benzidine, N,N'-bis(3-methylphenyl)-N,N'-bis(phenyl)-benzidine, N,N'-bis(3-methylphenyl)-N,N'-bis(phenyl)-9,9-spirobifluorene, N,N'-bis(naphthalen-1-yl)-N,N'-bis(phenyl)-9,9-spirobifluorene, N,N'-bis(3-methylphenyl)-N,N'-bis(phenyl)-9,9-dimethyl-fluorene, N,N'-bis(naphthalen-1-yl)-N,N'-bis(phenyl)-9,9-dimethyl-fluorene, N,N'-bis(3-methylphenyl)-N,N'-bis(phenyl)-9,9-diphenyl-fluorene, N,N'-bis(naphthalen-1-yl)-N,N'-bis(phenyl)-9,9-diphenyl-fluorene, N,N'-bis(naphthalen-1-yl)-N,N'-bis(phenyl)-2,2'-dimethylbenzidine, 2,2',7,7'-tetrakis(N,N-diphenylamino)-9,9-spirobifluorene, 9,9-bis[4-(N,N-bis-biphenyl-4-yl-amino)phenyl]-9H-fluorene, 9,9-bis[4-(N,N-bis-naphthalen-2-yl-amino)phenyl]-9H-fluorene, 9,9-bis[4-(N-naphthalen-1-yl-N-phenylamino)-phenyl]-9H-fluorene, 2,2',7,7' -tetrakis[N-naphthalenyl(phenyl)-amino]-9,9-spirobifluorene, N,N'-bis(phenanthren-9-yl)-N,N'-bis(phenyl)-benzidine, 2,2'-bis[N,N-bis(biphenyl-4-yl)amino]-9,9-spirobifluorene, 2,2'-bis(N,N-diphenylamino)-9,9-spirobifluorene, di-[4-(N,N-di(p-tolyl)amino)-phenyl]cyclohexane, 2,2',7,7' -tetra(N,N-di(p-tolyl))amino-9,9-spirobifluorene, N,N,N',N'-tetra-naphthalen-2-yl-benzidine, N,N,N',N'-tetra-(3-methylphenyl)-3,3'-dimethylbenzidine, N,N'-di(naphthalenyl)-N,N'-di(naphthalen-2-yl)-benzidine, N,N,N',N'-tetra(naphthalenyl)-benzidine, N,N'-di(naphthalen-2-yl)-N,N'-diphenylbenzidine-1,4-diamine, N¹,N⁴-diphenyl-N¹,N⁴-di(m-tolyl)benzene-1,4-diamine, N²,N²,N⁶,N⁶-tetraphenylnaphthalene-2,6-diamine, tris(4-(quinolin-8-yl)phenyl)amine, 2,2'-bis(3-(N,N-di(p-tolyl)amino)phenyl)biphenyl, 4,4',4"-tris[3-methylphenyl(phenyl)amino]triphenylamine (m-MTDATA), and 4,4',4"-tris[1-naphthyl(phenyl)amino]triphenylamine (1-TNATA); and oligothiophenes such as 5,5"-bis-{4-[bis(4-methylphenyl)amino]phenyl}-2,2':5',2"-terthiophene (BMA-3T).

Examples of materials for forming the light-emitting layer include tris(8-quinolinolate) aluminum(III) (Alq₃), bis(8-quinolinolate) zinc(II) (Znq₂), bis(2-methyl-8-quinolinolate)(p-phenylphenolate) aluminum(III) (BAlq), 4,4'-bis(2,2-diphenylvinyl)biphenyl, 9,10-di(naphthalen-2-yl)anthracene, 2-t-butyl-9,10-di(naphthalen-2-yl)anthracene, 2,7-bis[9,9-di(4-methylphenyl)-fluoren-2-yl]-9,9-di(4-methylphenyl)fluorene, 2-methyl-9,10-bis(naphthalen-2-yl)anthracene, 2-(9,9-spirobifluoren-2-yl)-9,9-spirobifluorene, 2,7-bis(9,9-spirobifluoren-2-yl)-9,9-spirobifluorene, 2-[9,9-di(4--methylphenyl)-fluoren-2-yl]-9,9-di(4-methylphenyl)fluorene, 2,2'-dipyrenyl-9,9-spirobifluorene, 1,3,5-tris(pyren-1-yl)benzene, 9,9-bis[4-(pyrenyl)phenyl]-9H-fluorene, 2,2'-bi(9,10-diphenylanthracene), 2,7-dipyrenyl-9,9-spirobifluorene, 1,4-di(pyren-1-yl)benzene, 1,3-di(pyren-1-yl)benzene, 6,13-di(biphenyl-4-yl)pentacene, 3,9-di(naphthalen-2-yl)perylene, 3,10-di(naphthalen-2-yl)perylene, tris[4-(pyrenyl)-phenyl]amine, 10,10' -di(biphenyl-4-yl)-9,9' -bianthracene, N,N'-di(naphthalen-1-yl)-N,N'-diphenyl-[1,1':4',1":4",1"'-quaterphenyl]-4,4"'-diamine, 4,4'-di[10-(naphthalen-1-yl)anthracen-9-yl]biphenyl, dibenzo{[f,f']-4,4',7,7'-tetraphenyl}diindeno[1,2,3-cd:1',2',3'-lm]perylene, 1-(7-(9,9'-bianthracen-10-yl)-9,9-dimethyl-9H-fluoren-2-yl)pyrene, 1-(7-(9,9' -bianthracen-10-yl)-9,9-dihexyl-9H-fluoren-2-yl)pyrene, 1,3-bis(carbazol-9-yl)benzene), 1,3,5-tris(carbazol-9-yl)benzene, 4,4',4"-tris(carbazol-9-yl)triphenylamine, 4,4'-bis(carbazol-9-yl)biphenyl (CBP), 4,4'-bis(carbazol-9-yl)-2,2'-dimethylbiphenyl, 2,7-bis(carbazol-9-yl)-9,9-dimethylfluorene, 2,2',7,7'-tetrakis(carbazol-9-yl)-9,9-spirobifluorene, 2,7-bis(carbazol-9-yl)-9,9-di(p-tolyl)fluorene, 9,9-bis[4-(carbazol-9-yl)-phenyl]fluorene, 2,7-bis(carbazol-9-yl)-9,9-spirobifluorene, 1,4-bis(triphenylsilyl)benzene, 1,3-bis(triphenylsilyl)benzene, bis(4-N,N-diethylamino-2-methylphenyl)-4-methylphenylmethane, 2,7-bis(carbazol-9-yl)-9,9-dioctylfluorene, 4,4"-di(triphenylsilyl)-p-terphenyl, 4,4'-di(triphenylsilyl)biphenyl, 9-(4-t-butylphenyl)-3,6-bis(triphenylsilyl)-9H-carbazole, 9-(4-t-butylphenyl)-3,6-ditrityl-9H-carbazole, 9-(4-t-butylphenyl)-3,6-bis(9-(4-methoxyphenyl)-9H-fluoren-9-yl)-9H-carbazole, 2,6-bis(3-(9H-carbazol-9-yl)phenyl)pyridine, triphenyl(4-(9-phenyl-9H-fluoren-9-yl)phenyl)silane, 9,9-dimethyl-N,N-diphenyl-7-(4-(1-phenyl-1H-benzo[d]imidazol-2-yl)phenyl)-9H-fluoren-2-amine, 3,5-bis(3-(9H-carbazol-9-yl)phenyl)pyridine, 9,9-spirobifluoren-2-yl-diphenyl-phosphine oxide, 9,9' -(5 -triphenyl silyl)-1,3 -phenylene)bis(9H-carb azole), 3-(2,7-bis(diphenylphosphoryl)-9-phenyl-9H-fluoren-9-yl)-9-phenyl-9H-carbazole, 4,4,8,8,12,12-hexa(p-tolyl)-4H-8H-12H-12C-azadibenzo[cd,mn]pyrene, 4,7-di(9H-carbazol-9-yl)-1,10-phenanthroline, 2,2'-bis(4-(carbazol-9-yl)phenyl)biphenyl, 2,8-bis(diphenylphosphoryl)dibenzo[b,d]thiophene, bis(2-methylphenyl)diphenylsilane, bis[3,5-di(9H-carbazol-9-yl)phenyl]diphenylsilane, 3,6-bis(carbazol-9-yl)-9-(2-ethyl-hexyl)-9H-carbazole, 3-(diphenylphosphoryl)-9-(4-(diphenylphosphoryl)phenyl)-9H-carbazole, and 3,6-bis[(3,5-diphenyl)phenyl]-9-phenylcarbazole. The light-emitting layer may be formed by co-deposition of any of these materials with a light-emitting dopant.

Examples of the light-emitting dopant include 3-(2-benzothiazolyl)-7-(diethylamino)coumarin, 2,3,6,7-tetrahydro-1,1,7,7-tetramethyl-1H,5H,11H-10-(2-benzothiazolyl)quinolidino[9,9a,1gh] coumarin, quinacridone, N,N'-dimethyl-quinacridone, tris(2-phenylpyridine) iridium(III) (Ir(ppy)₃), bis(2-phenylpyridine)(acetylacetonate) iridium(III) (Ir(ppy)₂(acac)), tris[2-(p-tolyl)pyridine] iridium(III) (Ir(mppy)₃), 9,10-bis[N,N-di(p-tolyl)amino]anthracene, 9,10-bis[phenyl(m-tolyl)amino]anthracene, bis[2-(2-hydroxyphenyl)benzothiazolate] zinc(II), N¹⁰,N¹⁰,N¹⁰,N¹⁰-tetra(p-tolyl)-9,9'-bianthracene-10,10'-diamine, N¹⁰,N¹⁰,N^{10'},N^{10'}-tetraphenyl-9,9'-bianthracene-10,10'-diamine, N¹⁰,N^{10'}-diphenyl-N¹⁰,N^{10'}-dinaphthalenyl-9,9'-bianthracene-10,10'-diamine, 4,4'-bis(9-ethyl-3-carbazovinylene)-1,1'-biphenyl, perylene, 2,5,8,11-tetra-t-butylperylene, 1,4-bis[2-(3-N-ethylcarbazolyl)vinyl]benzene, 4,4'-bis[4-(di-p-tolylamino)styryl]biphenyl, 4-(di-p-tolylamino)-4'-[(di-p-tolylamino)styryl]stilbene, bis[3,5-difluoro-2-(2-pyridyl)phenyl-(2-carboxypyridyl)] iridium(III), 4,4'-bis[4-(diphenylamino)styryl]biphenyl, bis(2,4-difluorophenylpyridinato)tetrakis(1-pyrazolyl)borate iridium(III), N,N'-bis(naphthalen-2-yl)-N,N'-bis(phenyl)-tris(9,9-dimethylfluorenylene), 2,7-bis{2-[phenyl(m-tolyl)amino]-9,9-dimethylfluoren-7-yl}-9,9-dimethyl-fluorene, N-(4-((E)-2-(6((E)-4-(diphenylamino)styryl)naphthalen-2-yl)vinyl)phenyl)-N-phenylbenzenamine, fac-iridium(III) tris(1-phenyl-3-methylbenzimidazolin-2-ylidene-C,C^{2'}), mer-iridium(III) tris(1-phenyl-3-methylbenzimidazolin-2-ylidene-C,C²), 2,7-bis[4-(diphenylamino)styryl]-9,9-spirobifluorene, 6-methyl-2-(4-(9-(4-(6-methylbenzo[d]thiazol-2-yl)phenyl)anthracen-10-yl)phenyl)-benzo[d]thiazole, 1,4-di[4-(N,N-diphenyl)amino]styrylbenzene, 1,4-bis(4-(9H-carbazole-9-yl)styryl)benzene, (E)-6-(4-(diphenylamino)styryl)-N,N-diphenylnaphthalen-2-amine, bis(2,4-difluorophenylpyridinato)(5-(pyridin-2-yl)-1H-tetrazolate) iridium(III), bis(3-trifluoromethyl-5-(2-pyridyl)pyrazole)((2,4-difluorobenzyl)diphenylphosphinate) iridium(III), bis(3-trifluoromethyl-5-(2-pyridyl)pyrazolate)(benzyldiphenylphosphinate) iridium(III), bis(1-(2,4-difluorobenzyl)-3-methylbenzimidazolium)(3-(trifluoromethyl)-5-(2-pyridyl)-1,2,4-triazolate) iridium(III), bis(3-trifluoromethyl-5-(2-pyridyl)pyrazolate)(4',6'-difluorophenylpyridinate) iridium(III), bis(4',6'-difluorophenylpyridinato)(3,5-bis(trifluoromethyl)-2-(2'-pyridyl)pyrrolate) iridium(III), bis(4',6'-difluorophenylpyridinato)(3-(trifluoromethyl)-5-(2-pyridyl)-1,2,4-triazolate) iridium(III), (Z)-6-mesityl-N-(6-mesitylquinolin-2(1H)-ylidene)quinoline-2-amine-BF₂, (E)-2-(2-(4-(dimethylamino)styryl)-6-methyl-4H-pyran-4-ylidene)malononitrile, 4-(dicyanomethylene)-2-methyl-6-julolidyl-9-enyl-4H-pyran, 4-(dicyanomethylene)-2-methyl-6-(1,1,7,7-tetramethyljulolidyl-9-enyl)-4H-pyran, 4-(dicyanomethylene)-2-t-butyl-6-(1,1,7,7-tetramethyljulolidin-4-yl-vinyl)-4H-pyran, tris(dibenzoylmethane)phenanthroline europium(III), 5,6,11,12-tetraphenylnaphthacene, bis(2-benzo[b]thiophen-2-yl-pyridine)(acetylacetonate) iridium(III), tris(1-phenylisoquinoline) iridium(III), bis(1-phenylisoquinoline)(acetylacetonate) iridium(III), bis[1-(9,9-dimethyl-9H-fluoren-2-yl)-isoquinoline](acetylacetonate) iridium(III), bis[2-(9,9-dimethyl-9H-fluoren-2-yl)quinoline](acetylacetonate) iridium(III), tris[4,4' -di-t-butyl-(2,2')-bipyridine] ruthenium(III). bis(hexafluorophosphate), tris(2-phenylquinoline) iridium(III), bis(2-phenylquinoline)(acetylacetonate) iridium(III), 2,8-di-t-butyl-5,11-bis(4-t-butylphenyl)-6,12-diphenyltetracene, bis(2-phenylbenzothiazolato)(acetylacetonate) iridium(III), platinum 5,10,15,20-tetraphenyltetrabenzoporphyrin, osmium(II) bis(3-trifluoromethyl-5-(2-pyridine)-pyrazolate)dimethylphenylphosphine, osmium(II) bis(3-trifluoromethyl)-5-(4-t-butylpyridyl)-1,2,4-triazolate)diphenylmethylphosphine, osmium(II) bis(3-(trifluoromethyl)-5-(2-pyridyl)-1,2,4-triazole)dimethylphenylphosphine, osmium(II) bis(3-(trifluoromethyl)-5-(4-t-butylpyridyl)-1,2,4-triazolate)dimethylphenylphosphine, bis[2-(4-n-hexylphenyl)quinoline](acetylacetonate) iridium(III), tris[2-(4-n-hexylphenyl)quinoline]iridium(III), tris[2-phenyl-4-methylquinoline] iridium(III), bis(2-phenylquinoline)(2-(3-methylphenyl)pyridinate) iridium(III), bis(2-(9,9-diethyl-fluoren-2-yl)-1-phenyl-1H-benzo[d]imidazolato)(acetylacetonate) iridium(III), bis(2-phenylpyridine)(3-(pyridin-2-yl)-2H-chromen-2-onate) iridium(III), bis(2-phenylquinoline)(2,2,6,6-tetramethylheptane-3,5-dionate) iridium(III), bis(phenylisoquinoline)(2,2,6,6-tetramethylheptane-3,5-dionate) iridium(III), iridium(III) bis(4-phenylthieno[3,2-c]pyridinato-N,C²)acetylacetonate, (E)-2-(2-t-butyl-6-(2-(2,6,6-trimethyl-2,4,5,6-tetrahydro-1H-pyrrolo[3,2,1-ij]quinolin-8-yl)vinyl)-4H-pyran-4-ylidene)malononitrile, bis(3-trifluoromethyl-5-(1-isoquinolyl)pyrazolate)(methyldiphenylphosphine) ruthenium, bis[(4-n-hexylphenyl)isoquinoline](acetylacetonate) iridium(III), platinum(II) octaethylporphin, bis(2-methyldibenzo[f,h]quinoxaline)(acetylacetonate) iridium(III), and tris[(4-n-hexylphenyl)xoquinoline] iridium(III).

Examples of materials for forming the electron-transporting layer/hole-blocking layer include lithium 8-hydroxyquinolinate, 2,2',2"-(1,3,5-benzinetriyl)-tris(1-phenyl-1-H-benzimidazole), 2-(4-biphenyl)-5-(4-t-butylphenyl)-1,3,4-oxadiazole, 2,9-dimethyl-4,7-diphenyl-1,10-phenanthroline, 4,7-diphenyl-1,10-phenanthroline, bis(2-methyl-8-quinolinolate)-4-(phenylphenolato)aluminum, 1,3-bis[2-(2,2'-bipyridin-6-yl)-1,3,4-oxadiazo-5-yl]benzene, 6,6'-bis[5-(biphenyl-4-yl)-1,3,4-oxadiazo-2-yl]-2,2'-bipyridine, 3-(4-biphenyl)-4-phenyl-5-t-butylphenyl-1,2,4-triazole, 4-(naphthalen-1-yl)-3,5-diphenyl-4H-1,2,4-triazole, 2,9-bis(naphthalen-2-yl)-4,7-diphenyl-1,10-phenanthroline, 2,7-bis[2-(2,2'-bipyridin-6-yl)-1,3,4-oxadiazo-5-yl]-9,9-dimethylfluorene, 1,3-bis[2-(4-t-butylphenyl)-1,3,4-oxadiazo-5-yl]benzene, tris(2,4,6-trimethyl-3-(pyridin-3-yl)phenyl)borane, 1-methyl-2-(4-(naphthalen-2-yl)phenyl)-1H-imidazo[4,5f][1,10]phenanthroline, 2-(naphthalen-2-yl)-4,7-diphenyl-1,10-phenanthroline, phenyl-dipyrenylphosphine oxide, 3,3',5,5'-tetra[(m-pyridyl)-phen-3-yl]biphenyl, 1,3,5-tris[(3-pyridyl)-phen-3-yl]benzene, 4,4'-bis(4,6-diphenyl-1,3,5-triazin-2-yl)biphenyl, 1,3-bis[3,5-di(pyridin-3-yl)phenyl]benzene, bis(10-hydroxybenzo[h]quinolinato)beryllium, diphenylbis(4-(pyridin-3-yl)phenyl)silane, and 3,5-di(pyren-1-yl)pyridine.

Examples of materials for forming the electron-injecting layer include lithium oxide (Li₂O), magnesium oxide (MgO), alumina (Al₂O₃), lithium fluoride (LiF), sodium fluoride (NaF), magnesium fluoride (MgF₂), cesium fluoride (CsF), strontium fluoride (SrF₂), molybdenum trioxide (MoO₃), aluminum, Li(acac), lithium acetate, and lithium benzoate.

Examples of the cathode material include aluminum, magnesium-silver alloy, aluminum-lithium alloy, lithium, sodium, potassium, and cesium.

Examples of material for forming the electron-blocking layer include tris(phenylpyrazole)iridium.

The method for fabricating a PLED device using the charge-transporting varnish of the invention is not particularly limited, but is exemplified by the following method.

A PLED device having a charge-transporting thin film formed using the charge-transporting varnish of the invention can be fabricated by, in the fabrication of an OLED device, successively forming a hole-transporting polymer layer and a light-emitting polymer layer, instead of carrying out vacuum deposition operations for a hole-transporting layer, a light-emitting layer, an electron-transporting layer, and an electron-injecting layer.

Specifically, the charge-transporting varnish of the invention is applied onto an anode substrate, thus forming a hole-injecting layer by the above-described method. A hole-transporting polymer layer and a light-emitting polymer layer are then successively formed thereon, following which a cathode is vapor-deposited on top, thereby forming a PLED device.

As the cathode and anode materials to be used, the same materials as those used for fabricating an OLED device can be used, and the same cleaning treatment and surface treatment can be carried out.

The method of forming the hole-transporting polymer layer and the light-emitting polymer layer is exemplified by a film-forming method in which a solvent is added to a hole-transporting polymer material or a light-emitting polymer material, or to the material obtained by adding to these a dopant substance, thereby dissolving or uniformly dispersing the material, following which the resulting solution or dispersion is applied onto the hole-injecting layer or hole-transporting polymer layer and then each baked.

Examples of the hole-transporting polymer material include poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-penten-5'-yl} fluorenyl-2,7-diyl)-co-(N,N'-bis{p-butylphenyl}-1,4-diaminophenylene)], poly[N,N'-bis(4-butylphenyl)-N,N'-bis(phenyl)benzidine]-end-capped with polysilsesquioxane, and poly[(9,9-dioctylfluorenyl-2,7-diyl)-co-(4,4'-(N-(p-butylphenyl))diphenylamine)].

Examples of the light-emitting polymer material include polyfluorene derivatives such as poly(9,9-dialkylfluorene) (PDAF), polyphenylene vinylene derivatives such as poly(2-methoxy-5-(2'-ethylhexoxy)-1,4-phenylene vinylene) (MEH-PPV), polythiophene derivatives such as poly(3-alkylthiophene) (PAT), and polyvinylcarbazole (PVCz).

Examples of the solvent include toluene, xylene, and chloroform. Examples of the method of dissolution or uniform dispersion include stirring, stirring and heating, and ultrasonic dispersion.

Examples of the coating method include, but are not particularly limited to, inkjet printing, spraying, dipping, spin coating, transfer printing, roll coating, and brush coating. Coating is preferably carried out in an inert gas atmosphere such as nitrogen or argon.

Examples of the baking method include methods that involve heating in an oven or on a hot plate, either in an inert gas atmosphere or in a vacuum.

It should be noted that, since not only the charge-transporting thin film obtained from the charge-transporting varnish described above, but also a vapor-deposited film obtained from the aniline derivative of the invention, has excellent charge transportability, the charge-transporting thin film obtained by vapor deposition may be used depending on the intended use.

The charge-transporting varnish of the invention is preferably used for forming a hole-injecting layer or a hole-transporting layer of an organic EL device as described above, and in addition, can also be used for forming a charge-transporting thin film in an electronic device such as an organic photoelectric conversion device, organic thin film solar cell, organic perovskite photoelectric conversion device, organic integrated circuit, organic field effect transistor, organic thin film transistor, organic light-emitting transistor, organic optical inspection device, organic photoreceptor, organic electric field quenching device, light-emitting electrochemical cell, quantum dot light-emitting diode, quantum laser, organic laser diode, and an organic plasmon light emitting device.

### EXAMPLES

Hereinafter, the invention is described more specifically with reference to Examples and Comparative Examples, but the invention is not limited to the following Examples. In addition, the equipment used is as follows.
(1) ¹H-NMR
   Nuclear magnetic resonance spectrometer AVANCE III HD 500 MHz, manufactured by Bruker BioSpin Corporation
(2) Substrate Cleaning:
   Substrate cleaning machine (reduced-pressure plasma system), manufactured by Choshu Industry Co., Ltd.
(3) Varnish Coating:
   MS-A100 Spin Coater, manufactured by Mikasa Co., Ltd.
(4) Film Thickness Measurement:
   Surfcorder ET-4000 microfigure measuring instrument, manufactured by Kosaka Laboratory, Ltd.
(5) EL Device Fabrication:
   C-E2L1G1-N Multifunction Vapor Deposition System, manufactured by Choshu Industry Co., Ltd.
(6) Measurement of Brightness, etc. of EL Device:
   I-V-L Measurement System, manufactured by Tech World, Inc.

### [1] Compound Synthesis

### [Synthesis Example 1] Synthesis of arylsulfonic acid

An aryl sulfonic acid of the following formula was synthesized according to WO 2006/025342.

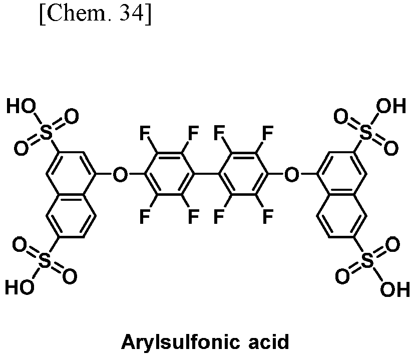

### [Synthesis Example 2] Synthesis of aryl sulfonate

An aryl sulfonate of the following formula was synthesized according to WO 2017/217455.

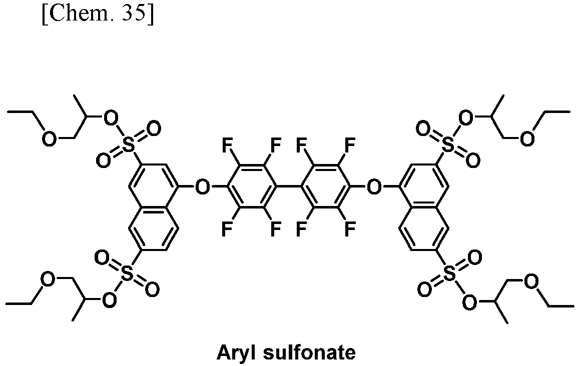

### [Synthesis Example 3] Synthesis of TBSCZ-Br

TBSCZ-Br of the following formula was synthesized according to Chemistry of Materials (2015), 27(19), 6535-6542. (hereinafter the same).

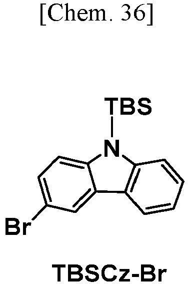

### [Synthesis Example 4] Synthesis of 21F-3TCz-TRI3

21F-3TCz-TRI3 of the following formula was synthesized according to WO 2015/050253.

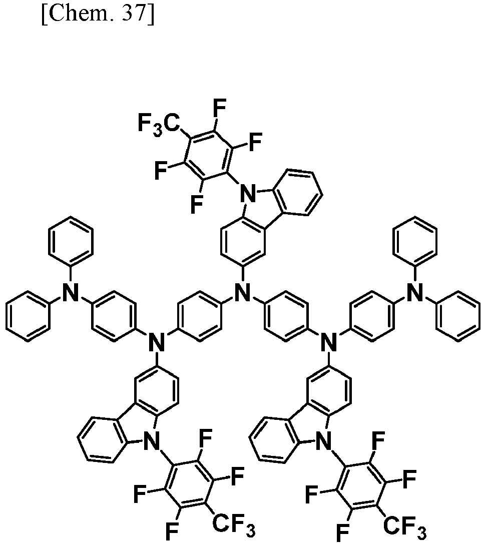

### [Example 1-1] Synthesis of aniline derivative TBSCz5

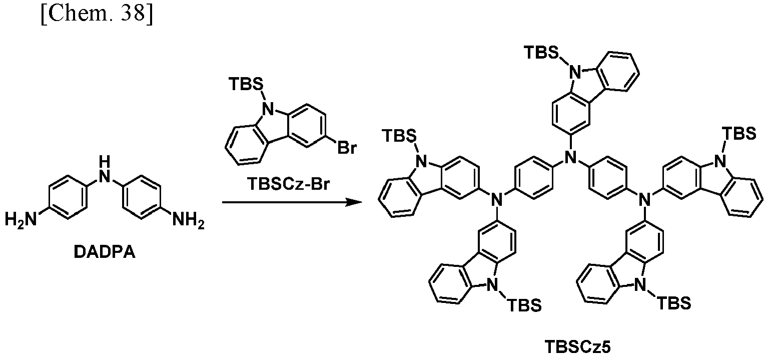

A flask was charged with 4.78 g of DADPA, 47.6 g of TBSCZ-Br, 1.38 g of Pd(dba)₂, and 16.6 g of t-butoxy sodium, following which the interior of the flask was replaced with nitrogen. Next, 240 mL of toluene and 20 mL of a previously prepared toluene solution of di-t-butyl(phenyl)phosphine (concentration: 55 g/L) were added thereto, and the mixture was stirred at 90°C. After 2.5 hours, the reaction solution was cooled to room temperature, 240 mL of ion-exchanged water was mixed, and liquid separation treatment was carried out. The organic layer was further separated and washed with ion-exchanged water and saturated saline, then dried over sodium sulfate, and concentrated. The resulting crude product was dissolved in 200 mL of toluene, and 3.5 g of Shirasagi P activated carbon (manufactured by Osaka Gas Chemicals Co., Ltd.) was added thereto. The mixture was stirred at room temperature for 2 hours and then filtered through silica gel, and cake washing was carried out with toluene. After the filtrate was concentrated to 240 g, the concentrate was added dropwise to a premixed solution of 7.02 g of N,N-diethyldithiocarbamate sodium trihydrate, 1.20 L of methanol, and 0.40 L of ethyl acetate, and the resulting slurry was stirred at room temperature. After 18 hours, the slurry was filtered, and cake washing of the filter product was carried out with methanol and then dried to obtain TBSCz5 (yield: 36.3 g, yield: 95%). The measurement result of ¹H-NMR is shown below.
¹H-NMR (500 MHz, THF-d₈) δ[ppm]: 7.88-7.98 (m, 10H), 7.55-7.61 (m, 10H), 7.19-7.30 (m, 10H), 7.12 (t, J = 7.3 Hz, 1H), 7.05 (t, J = 7.3 Hz, 4H), 6.96-7.00 (m, 8H), 1.05 (s, 36H), 1.04 (s, 9H), 0.74 (s, 30H).

### [Example 1-2] Synthesis of aniline derivative 3TBSCz-TRI3

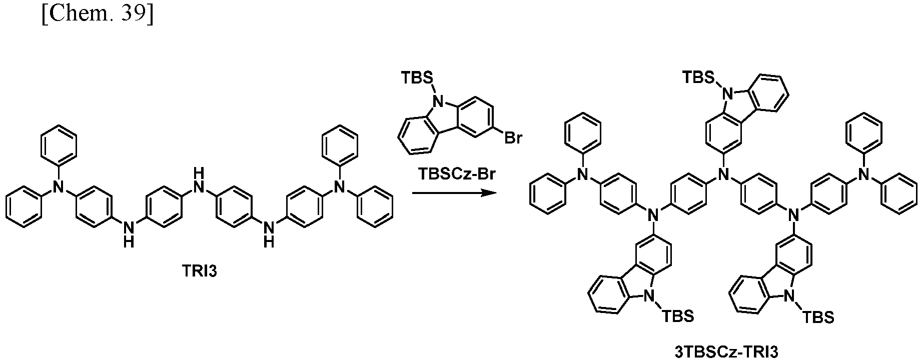

A flask was charged with 55.1 g of TRI3, 95.4 g of TBSCZ-Br, 2.77 g of Pd(dba)₂, and 32.4 g of t-butoxy sodium, following which the interior of the flask was replaced with nitrogen. Next, 550 mL of toluene and 22 mL of a previously prepared toluene solution of di-t-butyl(phenyl)phosphine (concentration: 96 g/L) were added thereto, and the mixture was stirred at 90°C. The reaction solution was cooled to room temperature for 1.5 hours, 550 mL of ion-exchanged water was mixed, and liquid separation treatment was carried out. To the resulting organic layer was added 11.0 g of Shirasagi P activated carbon (manufactured by Osaka Gas Chemicals Co., Ltd.), and the mixture was stirred at room temperature for 1 hour and then filtered through silica gel, and cake washing was carried out with toluene. The filtrate was concentrated to 660 g, the concentrate was added dropwise to a premixed solution of 22.0 g of N,N-diethyldithiocarbamate sodium trihydrate, 3.30 L of methanol, and 1.10 L of ethyl acetate, and the resulting slurry was stirred at room temperature. After 1 hour, the slurry was filtered, and cake washing of the filter product was carried out with methanol and then dried to obtain 3TBSCZ-TRI3 (yield: 112 g, yield: 92%). The measurement result of ¹H-NMR is shown below.
¹H-NMR (500 MHz, THF-d₈) δ[ppm]: 7.93-7.95 (m, 3H), 7.89 (d, J = 2.1 Hz, 3H), 7.57-7.62 (m, 6H), 7.26-7.30 (m, 3H), 7.15-7.21 (m, 11H), 7.06-7.13 (m,3H), 6.96-7.03 (m, 20H), 6.88-6.94 (m, 8H), 1.05 (s, 18H), 1.04 (s, 9H), 0.75 (s, 12H), 0.74 (s, 6H).

### [Example 1-3] Synthesis of aniline derivative 3TPA-TBSCz3

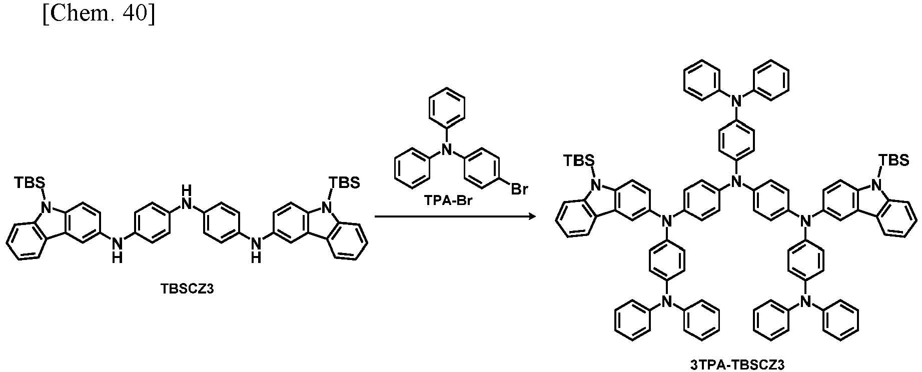

A flask was charged with 2.65 g of TBSCZ3, 3.74 g of TPA-Br, 121 mg of Pd(dba)₂, and 1.42 g of t-butoxy sodium, following which the interior of the flask was replaced with nitrogen. Next, 80 mL of toluene and 1.6 mL of a previously prepared toluene solution of di-t-butyl(phenyl)phosphine (concentration: 60 g/L) were added thereto, and the mixture was stirred at 90°C. After 4 hours, the reaction solution was cooled to room temperature, 100 mL of ion-exchanged water was mixed, and liquid separation treatment was carried out. Further, the organic layer was washed with an aqueous solution of 5% sodium N,N-diethyldithiocarbamate trihydrate, ion-exchanged water, and saturated saline, and then 0.1 g of Shirasagi P activated carbon (manufactured by Osaka Gas Chemicals Co., Ltd.) was added thereto. The mixture was stirred at room temperature for 1 hour and then filtered through silica gel, and cake washing was carried out with toluene. After the filtrate was concentrated, the resulting crude product was dissolved in 50 mL of toluene and added dropwise to a premixed solution of 375 mL of methanol and 125 mL of ethyl acetate, and the resulting slurry was stirred at room temperature. After 3 days, the slurry was filtered, and the filter product was dried to obtain 3TPA-TBSCz3 (yield: 4.80 g, yield: 92%). The measurement result of ¹H-NMR is shown below.
¹H-NMR (500 MHz, THF-d₈) δ[ppm]: 7.94 (d, J = 7.3 Hz, 2H), 7.89 (d, J = 1.8 Hz, 2H), 7.61 (t, J = 8.2 Hz, 4H), 7.29 (t, J = 7.3 Hz, 2H), 7.16-7.20 (m, 14H), 7.10 (t, J = 7.3 Hz, 2H), 6.98-7.04 (m, 26H), 6.89-6.94 (m, 12H).

The raw material TBSCZ3 was obtained as follows.

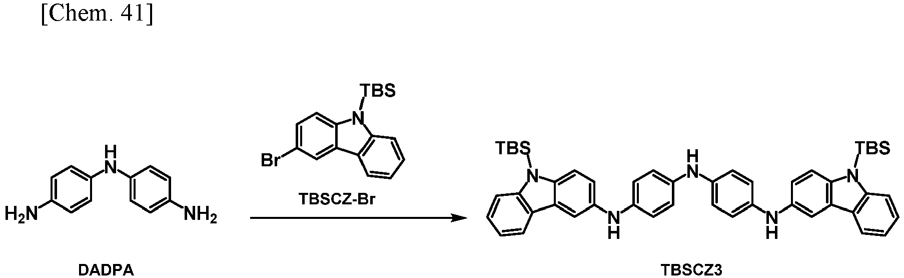

A flask was charged with 1.99 g of DADPA, 7.22 g of TBSCZ-Br, 233 mg of Pd(dba)₂, and 2.69 g of t-butoxy sodium, following which the interior of the flask was replaced with nitrogen. Next, 100 mL of toluene and 3.7 mL of a previously prepared toluene solution of di-t-butyl(phenyl)phosphine (concentration: 49 g/L) were added thereto, and the mixture was stirred at 90°C. After 2 hours, the reaction solution was cooled to room temperature, mixed with 100 mL of ion-exchanged water, and then filtered. The resulting filter product was dissolved in hot toluene, filtered while hot, and the filtrate was stirred at room temperature. After 18 hours, the precipitate was collected by filtration, washed with methanol, and then dried to obtain TBSCZ3 (yield: 3.87 g, yield: 51%). The measurement result of ¹H-NMR is shown below.
¹H-NMR (500 MHz, DMSO-d₆) δ[ppm]:
7.99 (d, J = 7.6 Hz, 2H), 7.68 (d, J = 2.1 Hz, 2H), 7.63 (s, 2H), 7.59 (d, J = 8.5 Hz, 2H), 7.52 (d, J = 8.9 Hz, 2H), 7.49 (s, 1H), 7.30-7.33 (m, 2H), 7.12-7.15 (m, 2H), 7.07 (dd, J = 8.9, 2.1 Hz, 2H), 6.94-7.02 (m, 8H), 0.98 (s, 18H), 0.73 (s, 12H).

### [Example 1-4] Synthesis of aniline derivative TBSCZ3-2PCZ

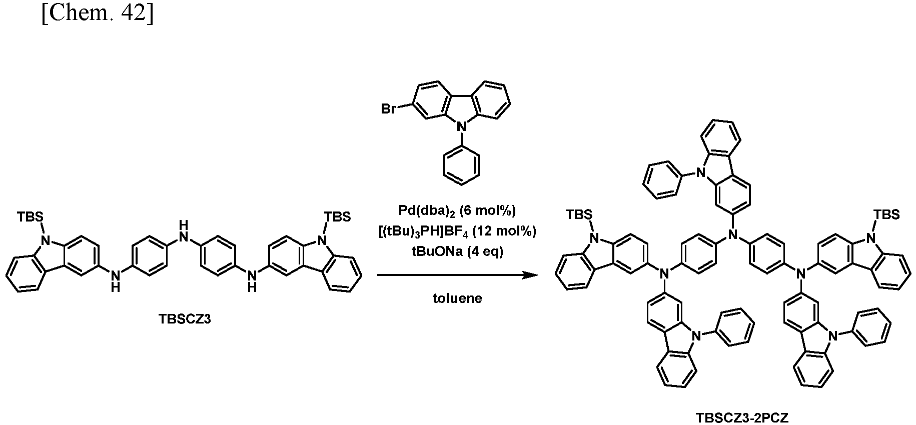

A flask was charged with 1.00 g of TBSCZ3 obtained above, 1.34 g of 2-bromophenylcarbazole, 46 mg of Pd(dba)₂, 99 mg of tri-tert-butylphosphonium tetrafluoroborate, 444 mg of t-butoxy sodium, and 30 mL of toluene, following which the interior of the flask was replaced with nitrogen. After stirring at 80°C for 1 hour, the mixture was returned to room temperature and filtered through celite. To the resulting filtrate was added 40 mL of saturated saline, liquid separation was performed, and the aqueous layer was removed. The resulting organic layer was filtered with silica gel. The resulting filtrate was concentrated under reduced pressure, and 40 mL of methanol was added. The precipitated solid was collected by filtration, washed with methanol, and then dried to obtain TBSCZ3-2PCZ (yield: 1.89 g, yield: 99%). The measurement result of ¹H-NMR is shown below.
¹H-NMR (500 MHz, DMSO-d₆) δ[ppm]:
8.31-8.01 (m, 8H), 7.95 (d, J = 2.3 Hz, 2H), 7.65 (t, J = 7.6 Hz, 4H), 7.55-7.12 (m, 30H), 7.04-6.90 (m, 14H), 1.00 (s, 18H), 0.74 (s, 12H).

### [2] Preparation of Charge-Transporting Varnish

### [Example 2-1]

Aryl sulfonic acid (0.097 g) was dissolved in a mixed solvent consisting of 1,3-dimethyl-2-imidazolidinone (DMI) (1.65 g), 2,3-butanediol (2 g), and dipropylene glycol monomethyl ether (DPM) (1.35 g), and then aniline derivative TBSCz5 (0.057 g) and 2,2,6,6-tetramethylpiperidine-N-oxyl (TEMPO) (manufactured by Tokyo Chemical Industry Co., Ltd.) (0.012 g) were added thereto, and the mixture was heated and stirred to prepare charge-transporting varnish A-1.

### [Example 2-2]

Aniline derivative TBSCz5 (0.064 g), aniline derivative 21F-3TCz-TRI3 (0.018 g), and an aryl sulfonate (0.126 g) were added to a mixed solvent consisting of 3-phenoxytoluene (1.5 g) and butyl benzoate (3.5 g), and the mixture was stirred to prepare charge-transporting varnish A-2.

### [Example 2-3]

Aryl sulfonic acid (0.099 g) was dissolved in a mixed solvent consisting of DMI (1.65 g), 2,3-butanediol (2 g), and DPM (1.35 g), and then aniline derivative 3TBSCz-TRI3 (0.056 g) and TEMPO (0.012 g) were added thereto, and the mixture was heated and stirred to prepare charge-transporting varnish B-1.

### [Example 2-4]

Aniline derivatives 3TBSCz-TRI3 (0.062 g), 21F-3TCz-TRI3 (0.019 g), and an aryl sulfonate (0.127 g) were added to a mixed solvent consisting of 3-phenoxytoluene (1.5 g) and butyl benzoate (3.5 g), and the mixture was stirred to prepare charge-transporting varnish B-2.

### [Example 2-5]

Aryl sulfonic acid (0.100 g) was dissolved in a mixed solvent consisting of DMI (1.65 g), 2,3-butanediol (2 g), and DPM (1.35 g), and then aniline derivative 3TPA-TBSCz3 (0.055 g) and TEMPO (0.012 g) were added thereto, and the mixture was heated and stirred to prepare charge-transporting varnish C-1.

### [Example 2-6]

Aniline derivatives 3TPA-TBSCz3 (0.061 g), 21F-3TCz-TRI3 (0.019 g), and an aryl sulfonate (0.128 g) were added to a mixed solvent consisting of 3-phenoxytoluene (1.5 g) and butyl benzoate (3.5 g), and the mixture was stirred to prepare charge-transporting varnish C-2.

### [Comparative Example 2-1]

Aryl sulfonic acid (0.108 g) was dissolved in a mixed solvent consisting of DMI (1.65 g), 2,3-butanediol (2 g), and DPM (1.35 g), and then aniline derivative 3Cz-TRI3 of the following formula (0.047 g) and TEMPO (0.012 g) were added thereto, and the mixture was heated and stirred to prepare charge-transporting varnish D-1.

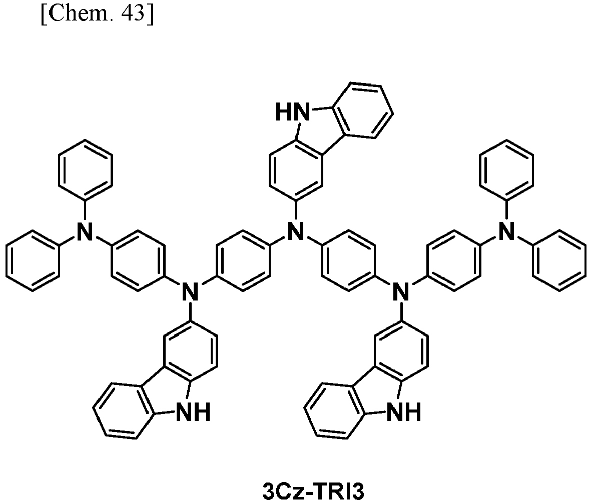

The aniline derivative 3Cz-TRI3 was synthesized by the following method.

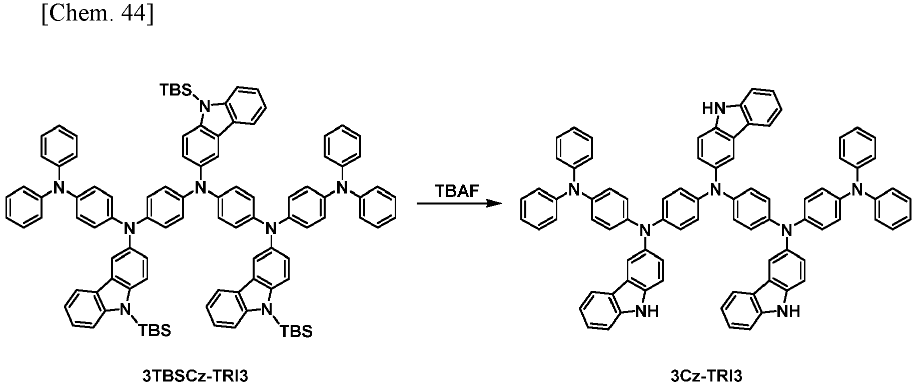

A flask was charged with 315 mL of THF and 105 g of 3TBSCZ-TRI3, then the mixture was stirred while cooling with an ice bath, and 310 mL of a THF solution of tetrabutylammonium fluoride (TBAF) (concentration: 1 M) was added dropwise. After completing the dropwise addition, the ice bath was removed, and the mixture was stirred at room temperature for 3 hours. Thereafter, the reaction solution was diluted with THF to 735 g, and this was added dropwise to 1.57 L of methanol to quench. The resulting precipitate was stirred at room temperature for 1 hour and then filtered, and cake washing was carried out with methanol. Thereafter, the resulting mixture was further subjected to slurry washing with 1.05 L of methanol for 2 hours. This was collected by filtration, and cake washing was carried out with methanol and then dried to obtain 3CZ-TRI3 (yield: 75.4 g, yield: 93%).

### [Comparative Example 2-2]

Aniline derivatives 3Cz-TRI3 (0.052 g), 21F-3TCz-TRI3 (0.020 g), and an aryl sulfonate (0.137 g) were added to a mixed solvent consisting of 3-phenoxytoluene (1.5 g) and butyl benzoate (3.5 g), and the mixture was stirred to prepare charge-transporting varnish D-2, but it was not completely dissolved and a varnish usable for forming a thin film was not obtained.

The varnishes prepared in Examples and Comparative Examples described above are summarized in Table 1. As shown in Table 1, the aniline derivative of Comparative Example was soluble only in the polar solvent, whereas the aniline derivatives of the invention showed good solubility in both the polar solvent and the nonpolar solvent.

**[Table 1]**

| | Varnish | Aniline derivative | Solvent species of varnish | Solubility |
|---|---|---|---|---|
| Example 2-1 | Varnish A-1 | TBSCz5 | Polar | ○ |
| Example 2-2 | Varnish A-2 | TBSCz5 | Nonpolar | ○ |
| Example 2-3 | Varnish B-1 | 3TBSCz-TRI3 | Polar | ○ |
| Example 2-4 | Varnish B-2 | 3TBSCz-TRI3 | Nonpolar | ○ |
| Example 2-5 | Varnish C-1 | 3TPA-TBSCz3 | Polar | ○ |
| Example 2-6 | Varnish C-2 | 3TPA-TBSCz3 | Nonpolar | ○ |
| Comparative Example 2-1 | Varnish D-1 | 3Cz-TRI3 | Polar | ○ |
| Comparative Example 2-2 | Varnish D-2 | 3Cz-TRI3 | Nonpolar | × |

### [3] Fabrication and Characterization Evaluation of Hole-Only Device (HOD)

In Examples and Comparative Examples described below, using a glass substrate 25 mm × 25 mm × 0.7 t on which ITO was patterned on the surface with a film thickness of 150 nm as the ITO substrate, impurities on the surface were removed by an O₂ plasma cleaning device (150 W, 30 seconds) before use.

### [Example 3-1]

The charge-transporting varnish A-1 was applied to the ITO substrate using a spin coater, then pre-baked at 120°C for 1 minute in the air, and subsequently main-baked at 230°C for 15 minutes to form a 50 nm thin film on the ITO substrate.

On top of that, α-NPD and an aluminum thin film were sequentially laminated using a vapor deposition system (vacuum degree 2.0×10⁻⁵ Pa) to obtain HOD. The vapor deposition was performed at a vapor deposition rate of 0.2 nm/sec. The film thicknesses of the α-NPD and the aluminum thin film were 30 nm and 80 nm, respectively.

In addition, in order to prevent characteristic deterioration due to influence of oxygen, water, and the like in the air, the characteristic of HOD was evaluated after sealing with a sealing substrate. Sealing was performed in the following procedure.

In a nitrogen atmosphere with an oxygen concentration of 10 ppm or less and a dew point of -75°C or less, HOD was placed between sealing substrates, and the sealing substrates were bonded together with an adhesive material (MORESCO Moisture Cut WB90US(P) manufactured by MORESCO Corporation). At this time, a water catching agent (HD-071010W-40, manufactured by DYNIC CORPORATION) was housed in the sealing substrate together with the HOD. The bonded sealing substrates were irradiated with UV light (wavelength 365 nm, irradiation amount 6,000 mJ/cm²), and then annealed at 80°C for 1 hour to cure the adhesive material.

### [Example 3-2]

A HOD was produced in the same manner as in Example 3-1, except that the charge-transporting varnish A-2 was used instead of the charge-transporting varnish A-1.

### [Example 3-3]

A HOD was produced in the same manner as in Example 3-1, except that the charge-transporting varnish B-1 was used instead of the charge-transporting varnish A-1.

### [Example 3-4]

A HOD was produced in the same manner as in Example 3-1, except that the charge-transporting varnish B-2 was used instead of the charge-transporting varnish A-1.

### [Example 3-5]

A HOD was produced in the same manner as in Example 3-1, except that the charge-transporting varnish C-1 was used instead of the charge-transporting varnish A-1.

### [Comparative Example 3-1]

A HOD was produced in the same manner as in Example 3-1, except that the charge-transporting varnish D-1 was used instead of the charge-transporting varnish A-1.

The current density at a driving voltage of 5 V was measured for each HOD produced in Examples and Comparative Examples described above. Results thereof are shown in Table 2.

**[Table 2]**

| | Varnish | Aniline derivative | Current density (mA/cm²) |
|---|---|---|---|
| Example 3-1 | Varnish A-1 | TBSCz5 | 2409 |
| Example 3-2 | Varnish A-2 | TBSCz5 | 2842 |
| Example 3-3 | Varnish B-1 | 3TBSCz-TRI3 | 3461 |
| Example 3-4 | Varnish B-2 | 3TBSCz-TRI3 | 3453 |
| Example 3-5 | Varnish C-1 | 3TPA-TBSCz3 | 3564 |
| Comparative Example 3-1 | Varnish D-1 | 3Cz-TRI3 | 3111 |

As shown in Table 2, the HODs produced using a polar solvent varnish containing the aniline derivative of the invention and a non-polar solvent varnish show equivalent or higher current characteristics of those of the HOD produced using a polar solvent varnish containing the aniline derivative of Comparative Example.

## Claims

1. An aniline derivative of formula (1): 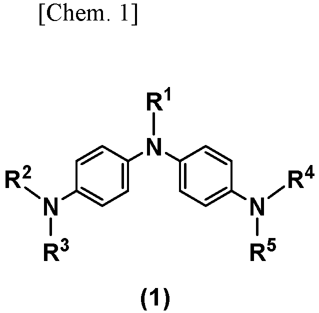 wherein R¹ to R⁵ are each independently a hydrogen atom, or a group of formula (2) or formula (3) 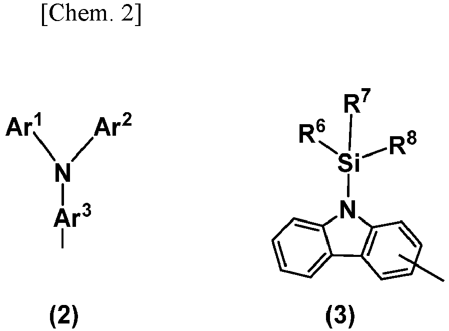 (wherein Ar¹ and Ar² are each independently an aryl group of 6 to 20 carbon atoms, Ar³ is an arylene group of 6 to 20 carbon atoms, and any two of Ar¹ to Ar³ may be bonded to each other to form a ring with a nitrogen atom, R⁶ to R⁸ are each independently an alkyl group of 1 to 20 carbon atoms or aryl group of 6 to 20 carbon atoms which may be substituted with W¹, and W¹ is a halogen atom, a nitro group, an alkoxy group of 1 to 20 carbon atoms, or a cyano group)
and at least one of R¹ to R⁵ is a group of formula (3).

2. The aniline derivative of claim 1, wherein R¹ to R⁵ are all groups of formula (3).

3. The aniline derivative of claim 1 or 2, wherein R⁶ to R⁸ are alkyl groups of 1 to 10 carbon atoms or aryl groups of 6 to 10 carbon atoms.

4. The aniline derivative of claim 3, wherein two of R⁶ to R⁸ are methyl groups and the remaining one is a t-butyl group.

5. A charge-transporting substance comprising the aniline derivative of any one of claims 1 to 4.

6. A charge-transporting material comprising the charge-transporting substance of claim 5.

7. A charge-transporting varnish comprising the charge-transporting substance of claim 5 and an organic solvent.

8. The charge-transporting varnish according to claim 7, further comprising a dopant.

9. The charge-transporting varnish of claim 8, wherein the dopant is at least one selected from aryl sulfonic acids and aryl sulfonates.

10. A charge-transporting thin film produced using the charge-transporting varnish of any one of claims 7 to 9.

11. An electronic device comprising the charge-transporting thin film of claim 10.

12. An organic electroluminescent device comprising the charge-transporting thin film of claim 10.

13. The organic electroluminescent device of claim 12, wherein the charge-transporting thin film is a hole-injecting layer or a hole-transporting layer.

14. A method for producing an aniline derivative of formula (1): 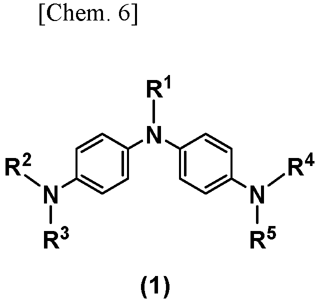 wherein R¹ to R⁵ are each independently a hydrogen atom, or a group of formula (2) or formula (3): 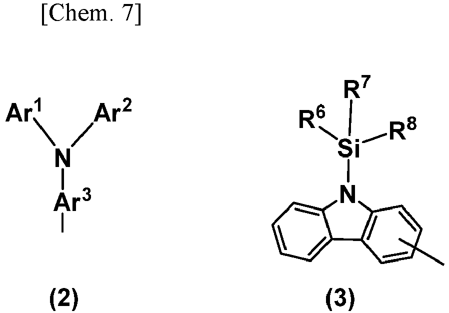 (wherein Ar¹ to Ar³ and R⁶ to R⁸ have the same meaning as below)
and at least one of R¹ to R⁵ is a group of formula (3),
the method comprising causing a coupling reaction of an amine compound of formula (1'): 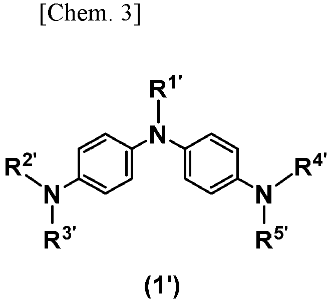 wherein R^{1'} to R^{5'} are each independently a hydrogen atom or a group of formula (2): 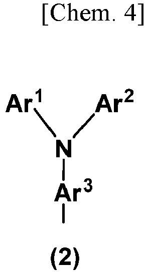 (wherein Ar¹ and Ar² are each independently an aryl group of 6 to 20 carbon atoms, Ar³ is an arylene group of 6 to 20 carbon atoms, and any two of Ar¹ to Ar³ may be bonded to each other to form a ring with a nitrogen atom)
and at least one of R^{1'} to R^{5'} is a hydrogen atom;
with a carbazole compound of formula (3'): 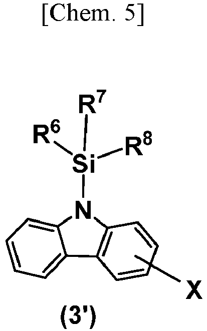 wherein X is a halogen atom or a pseudohalogen atom, R⁶ to R⁸ are each independently an alkyl group of 1 to 20 carbon atoms or aryl group of 6 to 20 carbon atoms which may be substituted with W¹, and W¹ is an alkoxy group of 1 to 20 carbon atoms, a halogen atom, a nitro group, or a cyano group,
in the presence of a catalyst and a base.
